(19) Europäisches Patentamt
European Patent Office
Office européen des brevets

(11) **EP 2 873 981 B1**

(12) **FASCICULE DE BREVET EUROPEEN**

(45) Date de publication et mention
de la délivrance du brevet:
**13.03.2019 Bulletin 2019/11**

(51) Int Cl.:
**G01R 21/133** *(2006.01)* **G01R 22/06** *(2006.01)*
**G01D 4/00** *(2006.01)* **G01R 19/00** *(2006.01)*

(21) Numéro de dépôt: **14192954.7**

(22) Date de dépôt: **13.11.2014**

(54) **Système de calcul de l'énergie électrique, armoire électrique comprenant un tel système, poste de transformation et procédé de calcul associés**

Berechnungssystem der elektrischen Energie, elektrischer Schaltschrank, der ein solches System umfasst, entsprechende Trafostation und entsprechendes Berechnungsverfahren

System for calculating electrical energy, electrical cabinet including such a system, related transforming station and calculation method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.11.2013 FR 1361222**

(43) Date de publication de la demande:
**20.05.2015 Bulletin 2015/21**

(73) Titulaire: **Schneider Electric Industries SAS**
**92500 Rueil-Malmaison (FR)**

(72) Inventeurs:
• **Coutelou, Olivier**
  **38050 GRENOBLE Cedex 09 (FR)**
• **Mollier, Christophe**
  **38050 GRENOBLE Cedex 09 (FR)**
• **Gaillard, Maxime**
  **38050 GRENOBLE Cedex 09 (FR)**
• **Sillans, Damien**
  **38050 GRENOBLE Cedex 09 (FR)**

(74) Mandataire: **Lavoix**
  **2, place d'Estienne d'Orves**
  **75441 Paris Cedex 09 (FR)**

(56) Documents cités:
**WO-A1-2013/017663    US-A- 5 517 106**
**US-B1- 8 014 964**

**Description**

La présente invention concerne un système de calcul de l'énergie électrique d'un courant alternatif circulant dans au moins un conducteur électrique secondaire étant relié électriquement à un conducteur électrique primaire, le conducteur primaire et le ou chaque conducteur secondaire présentant sensiblement la même tension alternative, le courant alternatif comportant au moins une phase.

Ce système de calcul comprend :

- un premier dispositif comportant un émetteur radioélectrique, un organe de mesure de la tension du conducteur primaire, des premiers moyens d'échantillonnage de la valeur de la tension mesurée, des moyens d'émission suivant une période d'émission d'un premier message, la période d'émission correspondant à un multiple de périodes de tension, la période de tension étant égale à l'inverse de la fréquence de la tension alternative, et des moyens de détermination d'un ensemble d'au moins une grandeur représentative de la tension mesurée, ledit ensemble étant déterminé en fonction de la valeur de la tension mesurée pendant une période d'émission donnée, le premier message contenant ledit ensemble ;
- au moins un deuxième dispositif comportant un capteur de l'intensité du courant circulant dans le conducteur secondaire correspondant, des seconds moyens d'échantillonnage de la valeur de l'intensité mesurée ; et
- au moins un organe de calcul de l'énergie électrique pour la ou chaque phase dudit courant circulant dans le conducteur secondaire correspondant, l'organe de calcul étant relié à au moins un deuxième dispositif correspondant et comportant un récepteur radioélectrique et des moyens de réception du premier message, le ou chaque organe de calcul étant propre à calculer une valeur de l'énergie électrique pendant la période d'émission donnée en fonction dudit ensemble contenu dans le premier message et des échantillons de l'intensité associés à la période d'émission donnée.

La présente invention concerne également une armoire électrique comprenant un tableau comportant des conducteurs électriques de départ, et un tel système de calcul.

La présente invention concerne également un poste de transformation d'un courant électrique présentant une première tension alternative en un courant électrique présentant une deuxième tension alternative, ce poste de transformation comprenant une telle armoire électrique, un tableau d'arrivée comportant au moins un conducteur électrique d'arrivée propre à être relié à un réseau électrique, le conducteur d'arrivée présentant la première tension alternative, le tableau de l'armoire formant un tableau de départ dont les conducteurs de départ correspondants présentent la deuxième tension alternative. Le poste de transformation comporte en outre un transformateur électrique connecté entre le tableau d'arrivée et le tableau de départ, le transformateur étant propre à transformer le courant présentant la première tension alternative en le courant présentant la deuxième tension alternative.

La présente invention concerne également un procédé de calcul de l'énergie électrique avec un tel système de calcul.

On connaît du document WO 2013/017663 A1 un système de calcul du type précité. Le système de calcul comprend un premier dispositif, appelé module primaire, comportant un émetteur radioélectrique, un organe de mesure de la tension du conducteur primaire, des moyens d'échantillonnage de la valeur de la tension mesurée, et des moyens d'émission d'un premier message. La période d'émission du premier message est égale à une seconde, et correspond à 50 périodes de tension, la période de tension étant égale à l'inverse de la fréquence de la tension alternative, soit 20 ms. Le système de calcul comprend également plusieurs deuxièmes dispositifs, appelés modules secondaires, chacun comportant un capteur de l'intensité du courant circulant dans le conducteur secondaire correspondant, des moyens d'échantillonnage de la valeur de l'intensité mesurée, et un organe de calcul de l'énergie électrique pour la ou chaque phase dudit courant circulant dans le conducteur secondaire correspondant.

Pour le calcul de l'énergie électrique, l'organe de calcul calcule, à chaque période de tension, c'est-à-dire toutes les 20 ms, une puissance active à partir des valeurs des intensités mesurées et des valeurs des tensions reçues dans le premier message. L'énergie active est alors calculée en incrémentant, pour chaque phase, un compteur positif d'énergie lorsque la puissance active calculée est positive, et en incrémentant un compteur négatif d'énergie lorsque la puissance active calculée est négative. L'énergie électrique est calculée pour la période d'émission donnée et en fonction d'un ensemble de grandeurs représentatives de la tension mesurée. Cet ensemble est déterminé pour une période de tension sélectionnée parmi la pluralité de périodes de tension pendant la période d'émission donnée, afin de limiter la quantité de données transmises par ondes radioélectriques entre les éléments du système pour le calcul de l'énergie électrique.

Toutefois, le calcul de l'énergie électrique à l'aide d'un tel système de calcul n'est pas optimal.

Le but de l'invention est de proposer un système de calcul plus précis.

A cet effet, l'invention a pour objet un système de calcul selon la revendication 1.

Avec le système de calcul selon l'invention, l'énergie électrique est calculée de manière plus précise, le coefficient correctif permettant de prendre en compte, pour le calcul de l'énergie, la valeur représentative de la tension au cours de plusieurs périodes de tension, à partir du moment où ladite valeur représentative est supérieure au seuil prédéterminé. La quantité de données transmises par ondes radioélectriques est en outre identique à celle transmise avec le système de calcul de l'état de la technique.

Avec le système de calcul de l'état de la technique, l'énergie est calculée à l'aide de ladite valeur représentative de la tension pour la seule période de tension sélectionnée parmi la pluralité de périodes de tension pendant la période d'émission donnée, et le calcul de l'énergie est donc moins précis qu'avec le système de calcul selon l'invention.

Suivant d'autres aspects avantageux de l'invention, le système de calcul comprend une ou plusieurs des caractéristiques suivante, prise(s) isolément ou suivant toutes les combinaisons techniquement possibles, selon les revendications dépendantes 2 à 7.

L'invention a également pour objet une armoire électrique selon la revendication 8.

L'invention a également pour objet un poste de transformation selon la revendication 9.

L'invention a également pour objet un procédé de calcul de l'énergie électrique selon la revendication 10.

Ces caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un poste de transformation comprenant un premier tableau, un deuxième tableau connecté au premier tableau par l'intermédiaire d'un transformateur et un système de calcul de l'énergie électrique du courant circulant dans des conducteurs de départ du deuxième tableau,
- la figure 2 est une représentation schématique du système de calcul de la figure 1, le système de calcul comprenant un premier dispositif de mesure de la tension, une pluralité de deuxièmes dispositifs de mesure de l'intensité et un dispositif de centralisation,
- la figure 3 est une représentation schématique du deuxième dispositif de la figure 2,
- la figure 4 est un organigramme des étapes d'un procédé de calcul selon l'invention, mises en oeuvre par le premier dispositif de la figure 2,
- la figure 5 est un organigramme des étapes du même procédé de calcul, mises en oeuvre par les deuxièmes dispositifs des figures 2 et 3,
- la figure 6 est un organigramme des étapes du même procédé de calcul, mises en oeuvre par le dispositif de centralisation de la figure 2,
- la figure 7 est un chronogramme représentant les instants d'émission et de réception d'un premier message, celui-ci étant émis par le premier dispositif à destination des deuxièmes dispositifs, et
- la figure 8 est un chronogramme représentant les périodes temporelles pour lesquelles des coefficients d'une décomposition en série de Fourier de la tension, et respectivement de l'intensité, sont déterminés et également les instants temporels de préparation du premier message, d'émission du premier message et de calcul de l'énergie électrique.

Dans la suite de la description, l'expression « sensiblement égal à » définit une relation d'égalité à plus ou moins 5 %.

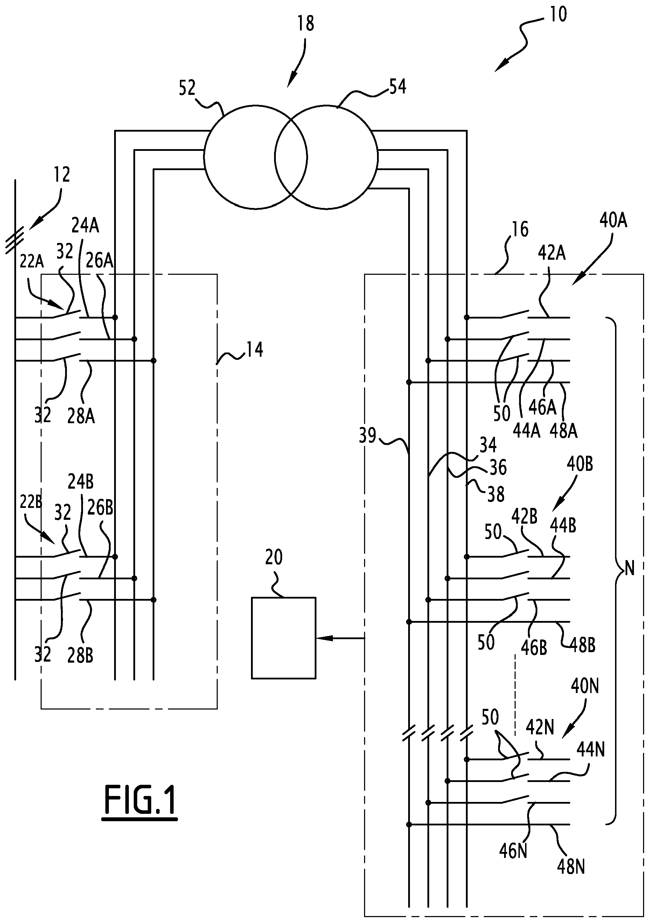

Sur la figure 1, un poste de transformation 10 connecté à un réseau électrique 12 comprend un premier tableau 14, également appelé tableau d'arrivée, un deuxième tableau 16, également appelé tableau de départ, un transformateur électrique 18 connecté entre le premier tableau et le deuxième tableau et un système 20 de mesure de l'énergie électrique d'un courant.

En variante, une armoire électrique, non représentée, comporte le deuxième tableau 16 et le système de mesure 20. Autrement dit, l'armoire électrique comporte les éléments du poste de transformation 10 à l'exception du transformateur électrique 18 et du premier tableau 14, le deuxième tableau 16 étant par exemple alimenté directement en basse tension.

Le poste de transformation 10 est propre à transformer le courant électrique délivré par le réseau 12 et présentant une première tension alternative, en un courant électrique présentant une deuxième tension alternative.

Le réseau électrique 12 est un réseau alternatif, tel qu'un réseau triphasé. Le réseau électrique 12 est, par exemple, un réseau moyenne tension, c'est-à-dire de tension supérieure à 1 000 V et inférieure à 50 000 V. La première tension triphasée est alors une moyenne tension. En variante, le réseau électrique 12 est un réseau haute tension, c'est-à-dire de tension supérieure à 50 000 V.

Le premier tableau 14 comporte plusieurs arrivées 22, chaque arrivée 22 comportant un premier 24A, 24B, un deuxième 26A, 26B, et un troisième 28A, 28B conducteurs d'arrivée. Chaque premier, deuxième, troisième conducteur d'arrivée 24A, 24B, 26A, 26B, 28A, 28B est relié au réseau électrique par l'intermédiaire d'un disjoncteur d'arrivée 32 respectif. Le courant triphasé circulant dans les conducteurs d'arrivée 24A, 24B, 26A, 26B, 28A, 28B correspondants présente la première tension triphasée.

Le deuxième tableau 16 comprend un premier 34, un deuxième 36, un troisième 38 et un quatrième 39 conducteurs primaires et une pluralité N de départs 40A, 40B, ...40N, à savoir un premier départ 40A, un deuxième départ 40B, ..., un Nième départ 40N, chaque départ 40A, 40B, ..., 40N étant propre à délivrer une tension triphasée.

Chaque départ 40A, 40B, 40N est un départ basse tension, c'est-à-dire de tension inférieure à 1 000 V. La deuxième tension triphasée est alors une basse tension. En variante, chaque départ 40A, 40B, ..., 40N est un départ moyenne tension, c'est-à-dire de tension est supérieure à 1 000 V et inférieure à 50 000 V.

Le premier départ 40A comporte un premier 42A, un deuxième 44A, un troisième 46A et un quatrième 48A conducteurs secondaires et trois disjoncteurs de départ 50. Les premier, deuxième et troisième conducteurs secondaires 42A, 42B, 42C sont respectivement reliés aux premier, deuxième et troisième conducteurs primaires 34, 36, 38 par l'intermédiaire d'un disjoncteur de départ 50 correspondant. Le quatrième conducteur secondaire 48A est directement connecté au quatrième conducteur primaire 39.

Les conducteurs primaires de départ 34, 36, 38 et les conducteurs secondaires de départ 42A, 44A, 46A correspondants présentent sensiblement la même tension, à savoir respectivement une première tension U1, une deuxième tension U2 et une troisième tension U3 correspondant aux trois phases de la deuxième tension triphasée.

Les autres départs 40B, ...40N sont identiques au premier départ 40A décrit précédemment, et comportent les mêmes éléments en remplaçant à chaque fois la lettre A par la lettre B, ..., N correspondante concernant les références des éléments.

Le transformateur électrique 18 est propre à transformer le courant issu du réseau électrique présentant la première tension alternative en le courant délivré au deuxième tableau 16 et présentant la deuxième tension alternative. Le transformateur électrique 18 comporte un enroulement primaire 52 connecté au premier tableau 14 et un enroulement secondaire 54 connecté au deuxième tableau 16.

Le système de calcul 20 est propre à calculer l'énergie électrique du courant circulant dans le ou chaque conducteur secondaire de départ 42A, 44A, 46A, 42B, 44B, 46B, ..., 42N, 44N, 46N.

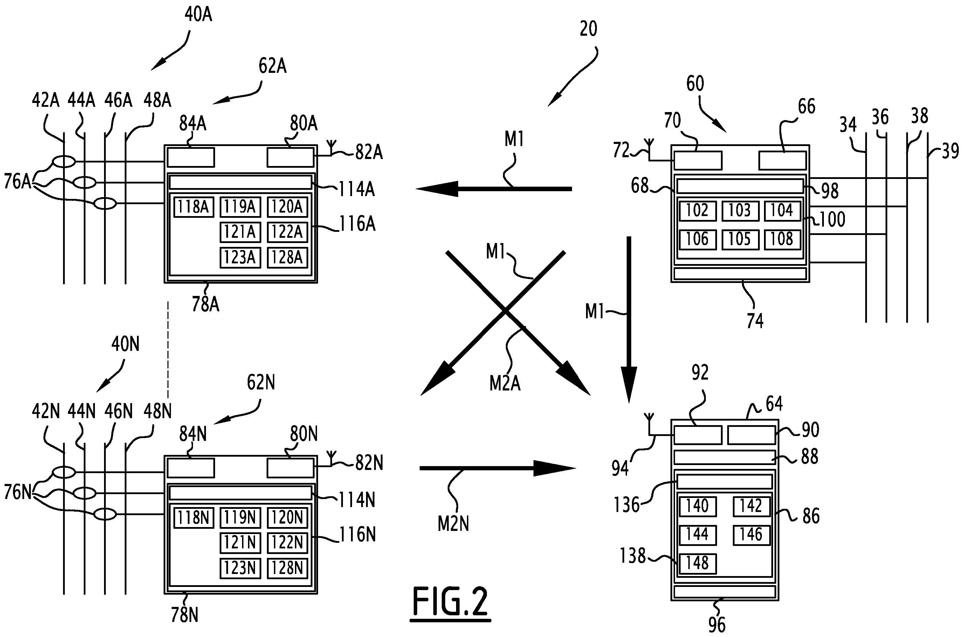

Le système de calcul 20, visible sur la figure 2, comprend un premier dispositif 60, une pluralité N de deuxièmes dispositifs 62A, 62B, ..., 62N, et un dispositif de centralisation 64.

Le premier dispositif 60 comporte un organe 66 de mesure de la tension du courant circulant dans le conducteur primaire 34, 36, 38 correspondant, et une unité 68 de traitement d'information. Le premier dispositif 60 comporte également un émetteur-récepteur radioélectrique 70, une antenne radioélectrique 72, et un organe 74 d'alimentation électrique de l'organe de mesure, de l'unité de traitement d'information et de l'émetteur-récepteur radioélectrique.

Le deuxième dispositif avec la référence 62A comporte, pour chacun des premier 42A, deuxième 44A et troisième 46A conducteurs secondaires, un capteur 76A de l'intensité du courant circulant dans le conducteur secondaire 42A, 44A, 46A correspondant. Le deuxième dispositif 62A comporte une unité 78A de traitement d'information, un émetteur-récepteur radioélectrique 80A, et une antenne radioélectrique 82A. Le deuxième dispositif 62A comporte également un organe 84A d'alimentation électrique de l'unité de traitement d'information et de l'émetteur-récepteur radioélectrique. Le deuxième dispositif 62A est identifié par un numéro unique, également appelé identifiant.

Les autres deuxièmes dispositifs 62B, ..., 62N sont identiques au deuxième dispositif 62A décrit précédemment, et comportent les mêmes éléments en remplaçant à chaque fois la lettre A par la lettre B, ..., N correspondante concernant les références des éléments. Chacun des autres deuxièmes dispositifs 62B, ..., 62N présente également un identifiant unique.

Le dispositif de centralisation 64 comporte une unité 86 de traitement d'information, une base de données 88 et une interface homme-machine 90. Le dispositif de centralisation 64 comporte un émetteur-récepteur radioélectrique 92, une antenne radioélectrique 94 et un organe 96 d'alimentation électrique de l'unité de traitement d'information, de la base de données, de l'interface homme-machine et de l'émetteur-récepteur radioélectrique.

L'organe de mesure 66 est propre à mesurer la première tension U1 de la phase circulant à travers le premier conducteur primaire 34, la deuxième tension U2 de la phase circulant à travers le deuxième conducteur primaire 36, et la troisième tension U3 de la phase circulant à travers le troisième conducteur primaire 38. L'organe de mesure 66 est également propre à mesurer la fréquence F de la tension triphasée circulant à travers les conducteurs primaires 34, 36, 38.

L'unité de traitement d'information 68 comporte un processeur 98 et une mémoire 100 apte à stocker un logiciel 102 de mesure des tensions U1, U2, U3 à l'aide de l'organe de mesure 66 et un premier logiciel 103 d'échantillonnage, avec une période d'échantillonnage $P_{ech}$ prédéterminée, de la valeur de la tension mesurée U1, U2, U3. Les échantillons de la tension mesurée U1, U2, U3 sont notés respectivement $U1_{k,m}$, $U2_{k,m}$, $U3_{k,m}$ où k est un indice d'une fenêtre d'échantillonnage de durée prédéterminée, associée à l'échantillonnage, et m est un indice d'échantillon variant entre 1 et $N_{ech}$, $N_{ech}$ étant un nombre entier représentant le nombre d'échantillons de tensions dans la fenêtre d'échantillonnage. La fenêtre d'échantillonnage est, par exemple, choisie égale à la période de tension $P_{tension}$, c'est-à-dire égale à l'inverse de la fréquence de tension F mesurée par l'organe de mesure 66.

La mémoire 100 est apte à stocker un premier logiciel 104 de détermination d'une pluralité de coefficients d'une transformée des échantillons $U1_{k,m}$, $U2_{k,m}$, $U3_{k,m}$ de chaque tension mesurée, jusqu'à un rang J de valeur supérieure ou égale à 1, de préférence supérieure ou égale à 5, de préférence encore égale à 17. Par convention, le rang égal à 1 correspond au fondamental de la transformée.

La mémoire 100 est apte à stocker un logiciel 105 d'émission d'un premier message M1 à destination de chaque deuxième dispositif 62A, ..., 62N et du dispositif de centralisation 64. Les instants d'émission de deux messages M1 successifs sont séparés par une période d'émission $P_{\text{émission}}$. Chaque période d'émission $P_{\text{émission}}$ présente de préférence une valeur prédéterminée, par exemple égale à une seconde.

Chaque période d'émission $P_{\text{émission}}$ correspond à un multiple de périodes de tension $P_{\text{tension}}$, la période de tension $P_{\text{tension}}$ étant égale à l'inverse de la fréquence F de la tension alternative U1, U2, U3. Le multiple est de préférence un nombre entier de valeur supérieure ou égale à 2, et la période d'émission $P_{\text{émission}}$ correspond alors à un multiple entier de périodes de tension $P_{\text{tension}}$.

En variante, le multiple est un nombre réel de valeur strictement supérieure à 1. Selon cette variante, un lissage de la valeur des échantillons de l'intensité mesurée sera alors effectué pour prendre en compte cette valeur non entière du multiple.

La mémoire 100 est apte à stocker un deuxième logiciel 106 de détermination d'un ensemble d'au moins une grandeur représentative de la tension mesurée U1, U2, U3, ledit ensemble étant déterminé en fonction de la valeur de la tension mesurée pendant une période d'émission donnée $P_{\text{émission}}$.

Dans la suite de la description, chaque période de tension est également référencée à l'aide de l'indice k, étant donné que la fenêtre d'échantillonnage est de préférence égale à la période de tension.

Selon un premier mode de réalisation, l'ensemble de grandeurs représentatives associées à la tension mesurée est déterminé en outre en fonction d'un coefficient correctif $\sigma_i$ associé à la période d'émission donnée $P_{\text{émission}}$. Le coefficient correctif $\sigma_i$ est, pour la ou chaque phase d'indice i, fonction d'une valeur représentative de la tension $U_i$ seulement pour chaque période de tension correspondante $P_{\text{tension}}$ où ladite valeur représentative est supérieure à un seuil prédéterminé $\varepsilon$.

La mémoire 100 est apte à stocker un logiciel 108 de distribution d'un unique jeton aux deuxièmes dispositifs 62A, ..., 62N de manière successive.

La transformée est, par exemple, une transformée de Fourier, et le premier logiciel de détermination 104 est propre à calculer les coefficients réel $\text{Re}\,U_{i,j,k}$, et imaginaire $\text{Im}\,U_{i,j,k}$ de la décomposition en série de Fourier des échantillons $U_{i_{k,m}}$ de chaque tension mesurée Ui, où i est un indice de la phase correspondante, par exemple respectivement égal à 1, 2 et 3, j est un rang de la décomposition en série de Fourier, avec j compris entre 1 et J, J étant égal au nombre de rangs de ladite décomposition, k est l'indice de la période de tension $P_{\text{tension}}$ correspondante, avec k compris entre 1 et K, K étant égal au nombre de périodes de tension $P_{\text{tension}}$ pendant une période d'émission $P_{\text{émission}}$. Dans l'exemple de réalisation, la période d'émission $P_{\text{émission}}$ est égale à une seconde et la période de tension $P_{\text{tension}}$ est égale à 20 ms, de sorte que K est égal à 50.

En variante, la transformée est une transformée de Laplace.

Le premier message M1 contient notamment l'ensemble de grandeurs représentatives déterminé par le deuxième logiciel de détermination 106.

Le premier message M1 contient également l'identifiant du deuxième dispositif qui sera autorisé à émettre son deuxième message à destination du dispositif de centralisation 64 après la réception du premier message M1. L'identifiant du deuxième dispositif autorisé à émettre ses informations de mesure est déterminé à l'aide du logiciel de distribution du jeton unique 108, l'identifiant du dispositif contenu dans le premier message M1 permettant de désigner le deuxième dispositif à qui l'unique jeton a été attribué.

L'émetteur-récepteur radioélectrique 70 est conforme au protocole de communication ZigBee basé sur la norme IEEE-802.15.4. En variante, l'émetteur-récepteur radioélectrique 70 est conforme à la norme IEEE-802.15.1, ou à la norme IEEE-802.15.2, ou encore à la norme IEEE-802-11 ou encore tout autre protocole radio propriétaire.

L'antenne radioélectrique 72 est adaptée pour émettre des signaux radioélectriques à destination des antennes 82A, ..., 82N des deuxièmes dispositifs et de l'antenne 94 du dispositif de centralisation, et également pour recevoir des signaux radioélectriques desdites antennes 82A, ..., 82N, 94. Autrement dit, le premier dispositif 60 est relié à chacun des deuxièmes dispositifs 62A, ..., 62N et au dispositif de centralisation 64 par une liaison radioélectrique correspondante.

L'organe d'alimentation 74 est propre à alimenter électriquement l'organe de mesure 66, l'unité de traitement d'information 68 et l'émetteur-récepteur radioélectrique 70 à partir de la tension triphasée circulant à travers les conducteurs primaires 34, 36, 38.

Chaque capteur de l'intensité 76A du deuxième dispositif 62A est propre à mesurer une intensité respective parmi une première intensité I1A circulant dans le premier conducteur secondaire de départ 42A, une deuxième intensité I2A circulant dans le deuxième conducteur secondaire de départ 44A et une troisième intensité I3A circulant dans le troisième conducteur secondaire de départ 46A.

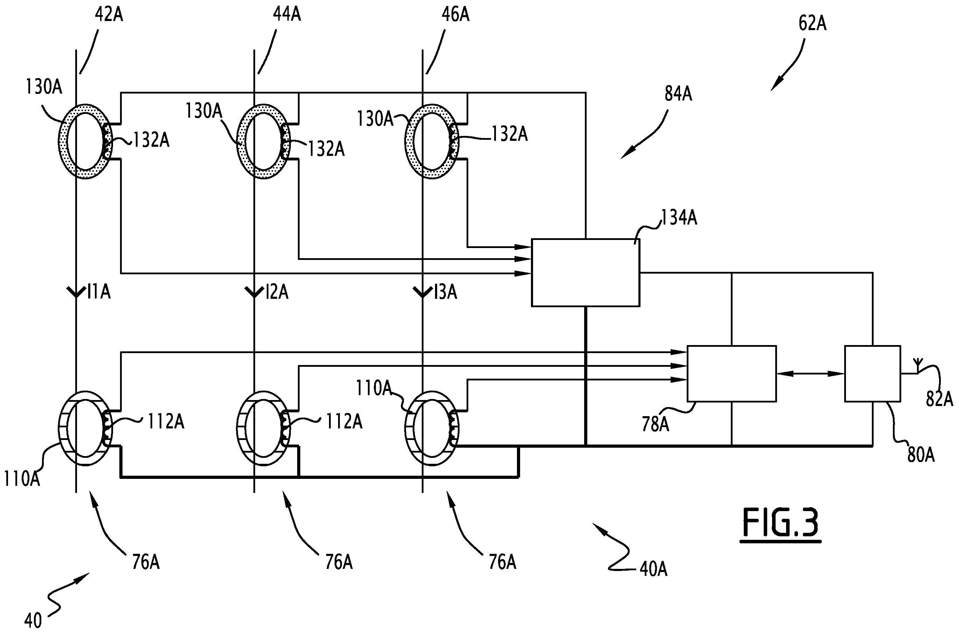

Chaque capteur de l'intensité 76A, également appelé capteur de courant, comporte un premier tore 110A disposé autour du conducteur secondaire de départ 42A, 44A, 46A correspondant et un premier enroulement 112A agencé autour du premier tore, comme représenté sur la figure 3. La circulation du courant à travers le conducteur secondaire de départ correspondant est propre à engendrer un courant induit proportionnel à l'intensité du courant dans le premier enroulement 112A. Le premier tore 110A est un tore de Rogowski. Le premier tore 110A est de préférence un tore ouvrant afin de faciliter son agencement autour des conducteurs correspondants.

L'unité de traitement d'information 78A, visible sur la figure 2, comporte un processeur de données 114A, et une mémoire 116A associée au processeur de données et propre à stocker un logiciel 118A de mesure des valeurs mesurées des intensités respectives et un second logiciel 119A d'échantillonnage, avec une période d'échantillonnage $P_{ech}$ prédéterminée, de la valeur des première, deuxième et troisième intensités I1A, I2A, I3A mesurées, et un logiciel 120A de réception du premier message M1.

Les échantillons des première, deuxième et troisième intensités I1A, I2A, I3A mesurées sont notés respectivement $I1A_{k,m}$, $I2A_{k,m}$, $I3A_{k,m}$ où k est l'indice de la fenêtre d'échantillonnage de durée prédéterminée, associée à l'échantillonnage, et m est l'indice d'échantillon variant entre 1 et $N_{ech}$, $N_{ech}$ étant le nombre entier représentant le nombre d'échantillons de tensions dans la fenêtre d'échantillonnage. La fenêtre d'échantillonnage est, par exemple, choisie égale à la période de tension $P_{tension}$, c'est-à-dire égale à l'inverse de la fréquence de tension F, cette valeur de la fréquence étant contenue dans chaque premier message M1 reçu.

La mémoire 116A est apte à stocker un troisième logiciel 121A de détermination d'une pluralité de coefficients d'une transformée des échantillons $I1A_{k,m}$, $I2A_{k,m}$, $I3A_{k,m}$ jusqu'au rang J . La transformée est, par exemple, une transformée de Fourier, et le troisième logiciel de détermination 121A est propre à calculer les coefficients réel $ReI_{iA,j,k}$, et imaginaire $ImI_{iA,j,k}$ de la décomposition en série de Fourier des échantillons $IiA_{k,m}$ de chaque intensité mesurée IiA, où i est l'indice de la phase correspondante, j est le rang de la décomposition en série de Fourier, avec j compris entre 1 et J, k est l'indice de la période de tension $P_{tension}$ correspondante, avec k compris entre 1 et K.

En variante, la transformée est une transformée de Laplace.

La mémoire 116A est apte à stocker un logiciel 122A de synchronisation de l'échantillonnage intensités I1A, I2A, I3A mesurées par rapport à l'échantillonnage de la tension mesurée U1, U2, U3. Par convention, la période de tension d'indice k égal à 1 correspond à la période temporelle au cours de laquelle le premier message M1 est émis par le premier dispositif 60 et respectivement reçu par chaque deuxième dispositif 62A, ..., 62N, et la période de tension d'indice k égal à 2 correspond à la période au début de laquelle la synchronisation des échantillonnages de tension et d'intensités est effectuée.

La mémoire 116A est apte à stocker un logiciel 123A de calcul de l'énergie électrique du courant circulant dans le conducteur secondaire 42A, 44A, 46A correspondant, telle que l'énergie active Ei.

En complément, la mémoire 116A est apte à stocker un logiciel 128A d'émission d'un deuxième message M2A à destination du dispositif de centralisation 64.

Le deuxième message M2A contient l'identifiant du deuxième dispositif 62A, les valeurs d'énergies actives $E_1$, $E_2$, $E_3$ pour l'ensemble des trois phases de la tension triphasée calculées par le logiciel de calcul 123A.

En complément, le deuxième message M2A contient les coefficients complexes $ReI_{iA,j,k}$, $ImI_{iA,j,k}$ de la décomposition en série de Fourier des trois courants I1A, I2A, I3A.

L'émetteur-récepteur radioélectrique 80A est du même type que l'émetteur-récepteur radioélectrique 70.

L'antenne radioélectrique 82A, du même type que l'antenne radioélectrique 72, est adaptée pour recevoir des signaux radioélectriques de l'antenne 72 du premier dispositif et de l'antenne 94 du dispositif de centralisation et également pour émettre des signaux radioélectriques aux antennes 72, 94.

L'organe d'alimentation 84A, visible sur la figure 3, est propre à alimenter l'unité de traitement d'information 78A et l'émetteur-récepteur radioélectrique 80A. L'organe d'alimentation 84A comporte, pour chacun des premier 42A, deuxième 44A et troisième 46A conducteurs secondaires, un deuxième tore 130A disposé autour du conducteur secondaire 42A, 44A, 46A correspondant et un deuxième enroulement 132A agencé autour du deuxième tore. La circulation du courant dans le conducteur secondaire 42A, 44A, 46A correspondant est propre à engendrer un courant induit dans le deuxième enroulement 132A.

L'organe d'alimentation 84A comporte un convertisseur 134A connecté à chacun des deuxièmes enroulements 132A et propre à délivrer une tension prédéterminée à l'unité de traitement d'information 78A et à l'émetteur-récepteur radioélectrique 80A. Chaque deuxième tore 130A est un tore en fer. Chaque deuxième tore 130A est de préférence un tore ouvrant afin de faciliter son agencement autour des conducteurs correspondants.

Autrement dit, le deuxième dispositif 62A est autoalimenté par l'intermédiaire de l'organe d'alimentation 84A comportant les deuxièmes tores 130A adaptés pour récupérer l'énergie magnétique issue de la circulation du courant dans les conducteurs secondaires 42A, 44A, 46A correspondants.

Les éléments des autres deuxièmes dispositifs 62B, ..., 62N sont identiques aux éléments du premier deuxième dispositif 62A décrits précédemment, et comportent les mêmes sous-éléments en remplaçant à chaque fois la lettre A par la lettre B, ..., N correspondante concernant les références des sous-éléments.

L'unité de traitement d'information 86 du dispositif de centralisation, visible sur la figure 2, comporte un processeur de données 136, et une mémoire 138 associée au processeur et apte à stocker un logiciel 140 de réception des premier et deuxièmes messages M1, M2A,..., M2N, un logiciel 142 d'enregistrement dans la base de données 88 des informations contenues dans les messages M1, M2A,..., M2N reçus. La mémoire 138 est propre à stocker un logiciel 144 de traitement desdites informations reçues, un logiciel 146 d'affichage de données et un logiciel 148 de transmission de données à destination d'un serveur distant, non représenté.

L'interface homme-machine 90 comporte un écran d'affichage et un clavier de saisie, non représentés.

L'émetteur-récepteur radioélectrique 92 est du même type que les émetteurs-récepteurs radioélectriques 70, 80A, ..., 80N.

L'antenne radioélectrique 94, du même type que les antennes radioélectriques 72, 82A, ..., 82N, est propre à recevoir des signaux radioélectriques issus de l'antenne 72 du premier dispositif et des antennes 82A, ..., 82N des deuxièmes dispositifs et également à émettre des signaux radioélectriques à destination desdites antennes 72, 82A, ..., 82N.

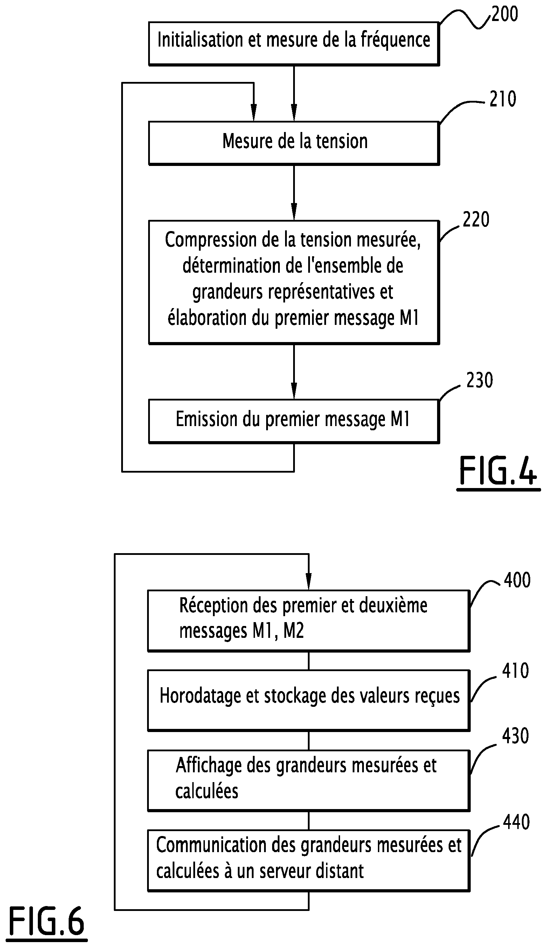

Le fonctionnement du système de calcul 20 va désormais être expliqué à l'aide des figures 4, 5 et 6 représentant des organigrammes des étapes d'un procédé de calcul mises en oeuvre respectivement par le premier dispositif 60, par les deuxièmes dispositifs 62A, ..., 62N et par le dispositif de centralisation 64.

Comme représenté sur la figure 4, lors d'une première étape 200, le premier dispositif 60 s'initialise et mesure la fréquence F de la tension triphasée circulant à travers les conducteurs primaires 34, 36, 38 par l'intermédiaire du logiciel de mesure 102. La fréquence F de la tension triphasée est, par exemple, égale à 50 Hz.

Le premier dispositif 60 mesure ensuite, lors de l'étape 210, les première, deuxième et troisième tensions U1, U2, U3 à l'aide de son organe de mesure 66 et de son logiciel de mesure 102.

Le premier logiciel d'échantillonnage 103 échantillonne ensuite les valeurs mesurées des tensions U1, U2, U3. La fréquence d'échantillonnage de la tension mesurée, égale à l'inverse de la période $P_{ech}$ d'échantillonnage, est un multiple de la fréquence F de ladite tension triphasée mesurée précédemment lors de l'étape 200. La période $P_{tension}$ de la tension triphasée est égale à la période du réseau, soit environ 20 ms en Europe et environ 16,66 ms aux Etats Unis. La période de tension $P_{tension}$ correspond à un multiple de la période d'échantillonnage $P_{ech}$.

Lors de l'étape 210, afin d'optimiser la précision de la mesure de l'énergie, la période $P_{tension}$ de la tension est mesurée régulièrement, par exemple toutes les 10 secondes, afin de prendre en compte des variations dans le temps de celle-ci.

Lors de l'étape 220, le premier dispositif 60 compresse les valeurs mesurées des tensions U1, U2, U3 en déterminant des coefficients réel Re$U_{i,j,k}$, et imaginaire Im$U_{i,j,k}$ de la décomposition en série de Fourier des échantillons Ui$_{k,m}$ de chaque tension mesurée U1, U2, U3 à l'aide de son premier logiciel de détermination 104. Ceci permet de limiter la quantité de données transmises par l'intermédiaire des liaisons radioélectriques entre le premier dispositif 60 et les deuxièmes dispositifs 62A, ..., 62N.

Les coefficients Re$U_{i,j,k}$, Im$U_{i,j,k}$ de la décomposition en série de Fourier sont, par exemple, obtenus par des opérations de corrélation sur les échantillons des valeurs mesurées. Plus précisément, le coefficient réel du fondamental, noté Re$U_{i,1,k}$, est une corrélation, sur une durée égale à la période $P_{tension}$ de la tension triphasée, entre les échantillons Ui$_{k,m}$ du signal de tension Ui et un cosinus de fréquence égale à la fréquence F de la tension triphasée, où Ui représente la tension de la phase, i étant égal à 1, 2 ou 3. Le coefficient imaginaire du fondamental, noté Im$U_{i,1,k}$, est une corrélation, sur une durée égale à la période $P_{tension}$, entre les échantillons Ui$_{k,m}$ du signal de tension Ui et un sinus de fréquence égal à la fréquence F.

Le coefficient réel de l'harmonique de rang j, noté Re$U_{i,j,k}$, j étant compris entre 2 et J, est la corrélation, sur une durée égale à la période $P_{tension}$, entre les échantillons Ui$_{k,m}$ du signal de tension Ui et un cosinus de fréquence égal à j fois la fréquence F. Le coefficient imaginaire de l'harmonique de rang j, noté Im$U_{i,j,k}$, est la corrélation, sur une durée égale à la période $P_{tension}$, entre les échantillons Ui$_{k,m}$ du signal de tension Ui et un sinus de fréquence égal à j fois la fréquence F.

Autrement dit, les coefficients Re$U_{i,j,k}$ et Im$U_{i,j,k}$ vérifient les équations suivantes, j étant compris entre 1 et J :

$$\mathrm{ReU}_{i,j,k} = \sum_{m=1}^{N_{ech}} \mathrm{Ui}_{k,m} \times \cos(2 \times \Pi \times \mathrm{F}_{tension} \times j \times m \times T) \qquad (1)$$

$$\mathrm{ImU}_{i,j,k} = \sum_{m=1}^{N_{ech}} \mathrm{Ui}_{k,m} \times \sin(2 \times \Pi \times \mathrm{F}_{tension} \times j \times m \times T) \qquad (2)$$

où T représente la période d'échantillonnage, également notée $P_{ech}$.

En variante, les coefficients Re$U_{i,j,k}$ et Im$U_{i,j,k}$ sont obtenus par une transformée de Fourier rapide, également appelée FFT (de l'anglais *Fast Fourier Transform*).

Le premier logiciel de détermination 104 calcule ainsi les coefficients complexes Re$U_{i,j,k}$ et Im$U_{i,j,k}$ des décompositions en série de Fourier des trois tensions U1, U2, U3 pour le fondamental et les harmoniques 2 à J.

Le deuxième logiciel de détermination 106 détermine ensuite au cours de l'étape 220 l'ensemble de grandeurs représentatives, celui-ci étant selon le premier mode de réalisation déterminé en fonction du coefficient correctif $\sigma_i$

associé à la période d'émission donnée P$_{\text{émission}}$. Le coefficient correctif $\sigma_i$ est fonction d'une valeur représentative de la tension U$_i$ pour chaque période de tension correspondante P$_{\text{tension}}$ où ladite valeur représentative est supérieure au seuil prédéterminé $\varepsilon$.

La valeur du seuil prédéterminé $\varepsilon$ est, par exemple, comprise entre 0,005 et 0,10 fois la valeur nominale Un de la tension, de préférence entre 0,01 et 0,05 fois la valeur nominale Un de la tension, de préférence encore égale à 0,02 fois la valeur nominale Un de la tension.

Ladite valeur représentative de la tension est de préférence la valeur du module du fondamental de la décomposition en série de Fourier de la tension, le module du fondamental étant noté $\|U_{i,1,k}\|$.

Le coefficient correctif $\sigma_i$ vérifie, par exemple, pour la ou chaque phase d'indice i, l'équation suivante :

$$\sigma_i = \frac{1}{k_{\max}} \times \sum_{\forall k\, /\, \|U_{i,1,k}\| \ge \varepsilon} \frac{\|U_{i,1,k}\|}{\|U_{i,1,k_0}\|} \tag{3}$$

où k est l'indice de la période de tension P$_{\text{tension}}$, avec k compris entre 1 et K, K étant égal au nombre de périodes de tension P$_{\text{tension}}$ pendant une période d'émission P$_{\text{émission}}$,

k$_0$ est l'indice d'une période de tension sélectionnée parmi la pluralité de périodes de tension P$_{\text{tension}}$, La valeur de l'indice k0 est de préférence égale à 2, car c'est la première période placée juste après la synchronisation et c'est donc la période sur laquelle les dérives des horloges ont le moins de prise sur la précision des calculs.

k$_{\max}$ est le nombre de périodes de tension pour lesquelles la valeur du module du fondamental de la décomposition en série de Fourier de la tension est supérieure au seuil prédéterminé $\varepsilon$ pendant la période d'émission donnée P$_{\text{émission}}$, et

$\|U_{i,1,k}\|$, respectivement $\|U_{i,1,k_0}\|$, représente le module du fondamental de la décomposition en série de Fourier de la tension pour la phase d'indice i et la période de tension d'indice k, et respectivement la période de tension sélectionnée d'indice k$_0$.

Le coefficient correctif $\sigma_i$ permet alors de prendre en compte la contribution des valeurs de la tension mesurée pour toutes les périodes de tension P$_{\text{tension}}$ au cours d'une période d'émission P$_{\text{émission}}$ donnée à partir du moment où le seuil $\varepsilon$ est dépassé, et pas seulement celle pour la période de tension sélectionnée d'indice k$_0$.

Le coefficient correctif $\sigma_i$ est, par exemple, appliqué aux coefficients complexes ReU$_{i,j,k0}$ et ImU$_{i,j,k0}$ avec j de valeur comprise entre 1 et J pour la période de tension sélectionnée d'indice k$_0$.

L'ensemble de grandeurs représentatives associées à la tension mesurée comprend alors les coefficients complexes modifiés, notés ReU$_{i,j}$ et ImU$_{i,j}$ obtenus à l'aide des équations suivantes :

$$\text{ReU}_{i,j} = \sigma_i \times \text{ReU}_{i,j,k_0} \tag{4}$$

$$\text{ImU}_{i,j} = \sigma_i \times \text{Im}U_{i,j,k_0} \tag{5}$$

L'ensemble de grandeurs représentatives est de préférence constitué desdits coefficients complexes modifiés ReU$_{i,j}$ et ImU$_{i,j}$.

Le champ de données du premier message M1 contient alors notamment les coefficients complexes modifiés ReU$_{i,j}$ et ImU$_{i,j}$ avec j de valeur comprise entre 1 et J formant l'ensemble de grandeurs représentatives déterminé.

Enfin, lors de l'étape 230, le premier dispositif 60 émet, à l'aide de son logiciel d'émission 105, le premier message M1 à destination de chacun des deuxièmes dispositifs 62A, ..., 62N et du dispositif de centralisation 64.

Le premier dispositif 60 lance en outre, lors de cette étape 230, une première temporisation égale à une durée de référence Df, à compter de l'instant de début d'émission du premier message M1, également appelé top d'émission Te du premier message M1. Lorsque cette première temporisation sera écoulée, le premier dispositif 60 débutera alors l'échantillonnage des valeurs mesurées des trois tensions U1, U2, U3, c'est-à-dire à un instant de début d'échantillonnage Tm égal à l'instant de début d'émission Te plus la durée de référence Df. L'échantillonnage, par le deuxième dispositif 62A, des valeurs mesurées des trois intensités I1A, I2A, I3A commencera également à cet instant de début d'échantillonnage Tm, comme cela sera décrit plus en détail par la suite en regard de l'étape de synchronisation 320.

La durée de référence Df a une valeur prédéterminée, par exemple sensiblement égale à 6 ms. La valeur de la durée de référence Df est connue à la fois du premier dispositif 60 et du deuxième dispositif 62A, et est choisie supérieure à la durée nécessaire à l'émission et à la réception du premier message M1. Dans l'exemple de réalisation décrit, la valeur de la durée de référence Df est stockée, préalablement à l'étape initiale 200, dans la mémoire 100 du premier dispositif et dans la mémoire 116A du deuxième dispositif 62A.

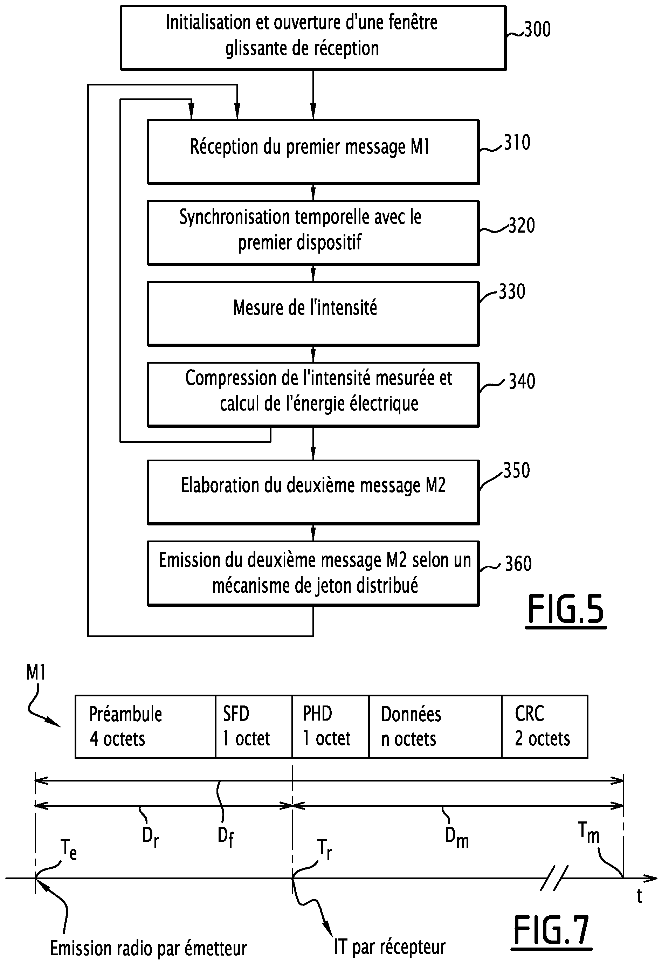

Le premier message M1 comprend un champ d'en-tête, également appelé préambule, un champ SFD (de l'anglais Start of Frame Delimiter), un champ PHR (de l'anglais Physical Header), un champ de données et un champ CRC (de l'anglais Cyclic Redundancy Check). Le préambule présente une taille de 4 octets, les champs SFD et PHR présentent chacun une taille d'un octet, le champ de données est de taille variable, notée n octets, et le champ CRC a une taille de 2 octets. Dans l'exemple de réalisation de la figure 7, le premier message M1 est constitué du champ d'en-tête, du champ SFD, du champ PHR, du champ de données et du champ CRC.

Le champ de données du premier message M1 contient notamment l'ensemble de grandeurs représentatives déterminé précédemment lors de l'étape 220, et l'identifiant du deuxième dispositif qui sera autorisé à émettre son deuxième message à destination du dispositif de centralisation 64 après la réception du premier message M1. L'identifiant du deuxième dispositif autorisé à émettre ses informations de mesure est déterminé à l'aide du logiciel de distribution du jeton unique 108, l'identifiant du dispositif contenu dans le premier message M1 permettant de désigner le deuxième dispositif à qui l'unique jeton a été attribué.

Après émission du premier message M1, le premier dispositif 60 retourne à l'étape 210 afin de mesurer à nouveau la tension U1, U2, U3 des phases de la tension triphasée circulant dans les conducteurs primaires 34, 36, 38.

Les étapes, visibles sur la figure 5, du procédé de calcul mises en oeuvre par les deuxièmes dispositifs 62A, ..., 62N vont être à présent décrites pour le deuxième dispositif avec la référence 62A.

Lors de l'étape 300, le deuxième dispositif 62A s'initialise et ouvre une fenêtre glissante de réception du premier message M1 à l'aide de son logiciel de réception 120A. La fenêtre de réception est une fenêtre présentant une durée de quelques dizaines de millisecondes que le deuxième dispositif 62A fait glisser dans le temps.

Lors de la réception du premier message M1, le deuxième dispositif 62A détecte l'instant Tr de réception du champ SFD, la réception du champ SFD entrainant le déclenchement d'une interruption par le récepteur radioélectrique du deuxième dispositif 62A, comme représenté sur la figure 7.

Le deuxième dispositif 62A passe alors à l'étape 320 de synchronisation temporelle avec le premier dispositif 60. La détection de l'instant de réception Tr permet de calculer, à l'aide du logiciel de synchronisation 122A, l'instant Tm de début de l'échantillonnage des valeurs mesurées des trois intensités I1A, I2A, I3A. L'instant de début de l'échantillonnage Tm est en effet égal à l'instant de réception Tr plus une durée de synchronisation Dm, la durée de synchronisation Dm étant égale à la durée de référence Df moins une durée de transmission radio Dr, comme représenté sur la figure 7. La durée de transmission radio Dr est une valeur dépendant de l'émetteur-récepteur radioélectrique 70 et de l'émetteur-récepteur radioélectrique 80A. La durée de transmission radio Dr correspond à la période temporelle entre l'instant de début d'émission Te et l'instant de réception Tr.

La durée de transmission radio Dr est par exemple sensiblement égale à 0,6 ms, et est connue du deuxième dispositif 62A. Dans l'exemple de réalisation décrit, la valeur de la durée de transmission radio Dr est stockée, préalablement à l'étape 300, dans la mémoire 116A du deuxième dispositif 62A.

Le deuxième dispositif 62A lance alors, à partir de l'instant de réception Tr et à l'aide du logiciel de synchronisation 122A, une deuxième temporisation égale à la durée de synchronisation Dm, la valeur de la durée de synchronisation Dm étant calculée par soustraction de la valeur de la durée de transmission radio Dr à la valeur de la durée de référence Df, la valeur de la durée de transmission radio Dr et la valeur de la durée de référence Df étant stockées dans la mémoire 116A comme décrit précédemment.

Le premier dispositif 60 avait par ailleurs lancé, lors de l'étape 230, la première temporisation égale à la durée de référence Df, de sorte que le premier dispositif 60 et le deuxième dispositif 62A commenceront simultanément l'échantillonnage des valeurs de tension mesurées, et respectivement des valeurs d'intensité mesurées, lorsque les première et deuxième temporisations lancées aux étapes 230 et 320 seront écoulées, c'est-à-dire à l'instant de début d'échantillonnage Tm.

Par convention, la période de tension correspondant à l'émission du premier message M1 est la période d'indice k égal à 1. Lorsque le premier message M1 a également été reçu au cours de la période de tension d'indice k égal à 1, l'instant de début d'échantillonnage suite à la synchronisation correspond alors au début de la période de tension d'indice k égal à 2.

La période de tension $P_{tension}$ est recalculée, par le deuxième logiciel d'échantillonnage 119A, à chaque réception de premier message M1 à l'aide de la valeur de la fréquence de tension F contenue dans le premier message M1.

Lors de l'étape 320, le logiciel de synchronisation 122A initialise, à la date de réception du premier message M1, un compteur destiné à s'incrémenter jusqu'à une valeur correspondant à la période d'émission du premier message $P_{émission}$. Le deuxième dispositif 62A retourne alors automatiquement à l'étape de réception 310 environ une milliseconde avant la réception attendue du prochain premier message M1.

Si le premier message M1 n'est pas détecté par le deuxième dispositif 62A, la fenêtre de réception est refermée et aucune synchronisation n'est effectuée. Le compteur est alors incrémenté pour une nouvelle tentative de synchronisation sur le message M1 probable suivant.

Le deuxième dispositif 62A mesure alors, lors de l'étape 330 et par l'intermédiaire de ses capteurs de courant 76A et de son logiciel de mesure 118A, chacune des première, deuxième et troisième intensités I1A, I2A, I3A.

Le deuxième logiciel d'échantillonnage 119A échantillonne ensuite les valeurs mesurées des trois intensités I1A, I2A, I3A, l'instant de début de l'échantillonnage Tm ayant été calculé lors de l'étape 320 précédente afin d'assurer la synchronisation temporelle du capteur de l'intensité 76A par rapport à l'organe de mesure de la tension 66.

Le troisième logiciel de détermination 121A compresse ensuite les valeurs mesurées des intensités I1A, I2A, I3A lors de l'étape 340. Le troisième logiciel de détermination 121A calcule, par exemple, les coefficients réel $ReI_{iA,j,k}$, et imaginaire $ImI_{iA,j,k}$ de la décomposition en série de Fourier des échantillons $IiA_{k,m}$ de chaque intensité mesurée I1A, I2A, I3A des trois phases de manière analogue au calcul, décrit pour l'étape 220, des coefficients complexes $ReU_{i,j,k}$, $ImU_{i,j,k}$ de la décomposition en série de Fourier des tensions.

Le coefficient réel du fondamental, également noté $ReI_{iA,1,k}$, est ainsi une corrélation, sur une durée égale à la période $P_{tension}$ de la tension triphasée, entre les échantillons du signal de l'intensité IiA et un cosinus de fréquence égal à la fréquence F de la tension triphasée, où IiA représente l'intensité de la phase numéro i, i étant égal à 1, 2 ou 3. Le coefficient imaginaire du fondamental, également noté $ImI_{iA,1,k}$, est une corrélation, sur une durée égale à la période $P_{tension}$, entre les échantillons du signal de l'intensité IiA et un sinus de fréquence égal à la fréquence F.

Le coefficient réel de l'harmonique de rang j, noté $ReI_{iA,j,k}$, j étant compris entre 2 et J, est la corrélation, sur une durée égale à la période $P_{tension}$, entre les échantillons du signal de l'intensité IiA et un cosinus de fréquence égal à j fois la fréquence F. Le coefficient imaginaire de l'harmonique de rang j, noté $ImI_{iA,j,k}$, j étant compris entre 2 et J, est la corrélation, sur une durée égale à la période $P_{tension}$, entre les échantillons du signal de l'intensité IiA et un sinus de fréquence égal à j fois la fréquence F.

Les coefficients $ReI_{iA,j,k}$, et $ImI_{iA,j,k}$ vérifient alors les équations suivantes :

$$\text{ReI}_{iA,j,k} = \sum_{m=1}^{N_{ech}} \text{IiA}_{k,m} \times \cos(2 \times \Pi \times F_{tension} \times j \times m \times T) \tag{6}$$

$$\text{ImI}_{iA,j,k} = \sum_{m=1}^{N_{ech}} \text{IiA}_{k,m} \times \sin(2 \times \Pi \times F_{tension} \times j \times m \times T) \tag{7}$$

Le logiciel de calcul 123A calcule alors de manière périodique l'énergie active $E_1$, $E_2$, $E_3$ pour chacune des trois phases à partir l'ensemble de grandeurs représentatives déterminé, précédemment reçu du premier dispositif 60 via le premier message M1, et des valeurs des intensités I1A, I2A, I3A mesurées par les capteurs de courant 76A. La période de calcul des énergies actives $E_1$, $E_2$, $E_3$ est égale à la période d'émission du premier message $P_{émission}$, soit par exemple 1 s.

Pour le calcul des énergies actives $E_1$, $E_2$, $E_3$, le logiciel de calcul 123A calcule, pour la période $P_{tension}$ d'indice k égal à $k_0$, la puissance active $P_{i,j,k0}$ pour chaque phase numéro i, i étant égal à 1, 2 ou 3, et pour chaque rang j compris entre 1 et J, à l'aide de l'équation suivante :

$$P_{i,j,k_0} = \frac{\left\lfloor \text{Re}U_{i,j} \times \text{Re}I_{iA,j,k_0} + \text{Im}U_{i,j} \times \text{Im}I_{iA,j,k_0} \right\rfloor}{2} \tag{8}$$

Le logiciel de calcul 123A détermine également, pour la période $P_{tension}$ d'indice k égal à $k_0$, la puissance réactive $Q_{i,j,k0}$ pour chaque phase numéro i, i étant égal à 1, 2 ou 3, et pour chaque rang j compris entre 1 et J, à l'aide de l'équation suivante :

$$Q_{i,j,k_0} = \frac{\left\lfloor \text{Im}U_{i,j} \times \text{Re}I_{iA,j,k_0} - \text{Re}U_{i,j} \times \text{Im}I_{iA,j,k_0} \right\rfloor}{2} \tag{9}$$

Le logiciel de calcul 123A détermine aussi le déphasage $\varphi_{i,j,k0}$, également noté $\varphi_{i,j}$, entre l'harmonique de la tension et l'harmonique du courant pour la période $P_{tension}$ d'indice k égal à $k_0$, de préférence égal à 2, pour chaque phase numéro i, i étant égal à 1, 2 ou 3, et pour chaque rang j compris entre 1 et J, à l'aide de l'équation suivante :

$$\varphi_{i,j} = \varphi_{i,j,k_0} = \arctan\left(\frac{Q_{i,j,k_0}}{P_{i,j,k_0}}\right) \qquad (10)$$

Le logiciel de calcul 123A détermine ensuite une tension efficace $U_{i,j}$eff pour chaque phase numéro i, i étant égal à 1, 2 ou 3, et pour chaque rang j compris entre 1 et J, à l'aide de l'équation suivante :

$$U_{i,j}eff = \sqrt{\frac{\left(\mathrm{Re}\, U_{i,j}\right)^2 + \left(\mathrm{Im}\, U_{i,j}\right)^2}{2}} \qquad (11)$$

Cette valeur de tension efficace est alors une valeur correspondant à l'ensemble des périodes de tension $P_{tension}$ à partir du moment où le seuil $\varepsilon$ est dépassé pour la période d'émission $P_{émission}$ donnée.

Le logiciel de calcul 123A détermine ensuite un courant efficace $I_{i,j,k}$eff pour chaque période $P_{tension}$ d'indice k compris entre 1 et K, pour chaque phase numéro i, i étant égal à 1, 2 ou 3, et pour chaque rang j compris entre 1 et J, à l'aide de l'équation suivante :

$$I_{i,j,k}eff = \sqrt{\frac{\left(\mathrm{Re}\, I_{i,j,k}\right)^2 + \left(\mathrm{Im}\, I_{i,j,k}\right)^2}{2}} \qquad (12)$$

L'énergie active $E_i$ de chaque phase numéro i est enfin calculée à l'aide des équations suivantes :

$$E_i = \sum_{j=1}^{J} E_{i,j} \qquad (13)$$

$$E_{i,j} = \sum_{k=1}^{K} P_{i,j,k} \times P_{émission} \qquad (14)$$

$$E_{i,j} = \sum_{k=1}^{K}\left[U_{i,j}eff \times I_{i,j,k}eff \times \cos(\varphi_{i,j})\right] \times P_{émission} = U_{i,j}eff \times \cos(\varphi_{i,j}) \times P_{émission} \times \sum_{k=1}^{K} I_{i,j,k}eff \qquad (15)$$

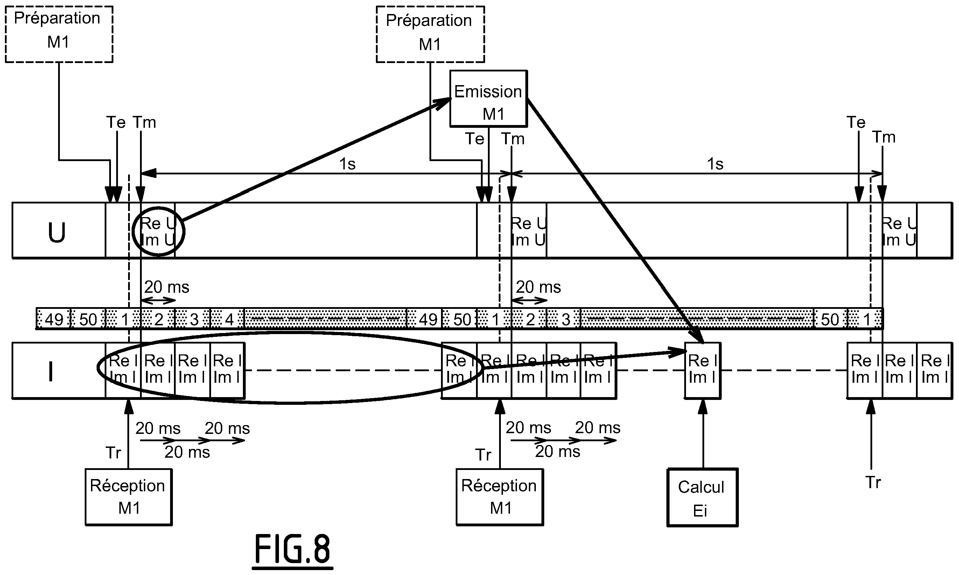

Le calcul des énergies actives $E_1$, $E_2$, $E_3$ est effectué à n'importe quel moment au cours d'une période d'émission $P_{émission}$ entre deux réceptions de message M1, les informations nécessaires au calcul étant contenues dans le premier message M1 reçu précédemment, pour ce qui concerne les informations relatives à la tension, ou dans la mémoire 116A du deuxième dispositif 62A, étant donné que les valeurs relatives aux tension et intensités prises en compte correspondent à la période d'émission $P_{émission}$ précédente. Dans l'exemple de la figure 8, le calcul des énergies actives $E_1$, $E_2$, $E_3$ est effectué sensiblement au milieu de la période d'émission.

Le deuxième dispositif 62A élabore alors, lors de l'étape 350, son deuxième message M2A. Le deuxième message M2A contient l'identifiant du deuxième dispositif 62A, les valeurs des énergies actives $E_1$, $E_2$, $E_3$ pour l'ensemble des trois phases de la tension triphasée et les coefficients complexes $\mathrm{Re}I_{iA,j,k}$, et $\mathrm{Im}I_{iA,j,k}$ de la décomposition en série de Fourier des trois courants I1A, I2A, I3A jusqu'à l'harmonique J.

En complément, le deuxième message M2A contient les valeurs des moyennes quadratiques, également notées RMS, des courants I1A, I2A, I3A des trois phases, ainsi que les termes $P_{i,j,k0}$ et $Q_{i,j,k0}$ pour chacune des trois phases.

Dans l'hypothèse où l'identifiant du deuxième dispositif 62A était contenu dans le premier message M1 reçu précédemment, le deuxième dispositif 62A émet alors lors de l'étape 360 son deuxième message M2A à l'aide de son logiciel d'émission 128A. Dans le cas contraire, le deuxième dispositif 62A retourne directement à l'étape 310 de réception du premier message M1, et émettra son deuxième message M2A lorsque le premier message M1 contiendra son identifiant indiquant alors que l'unique jeton lui aura été attribué afin de l'autoriser à émettre son deuxième message M2A.

Après l'étape d'émission 360 dans le cas où le jeton avait été attribué au deuxième dispositif 62A, ou bien après l'étape 350 autrement, le deuxième dispositif 62A retourne à l'étape de réception 310 si le compteur a atteint la valeur correspondant à la période d'émission $P_{\text{émission}}$, ou bien à l'étape de mesure 330 autrement.

Les étapes du procédé de calcul mises en oeuvre par les autres deuxièmes dispositifs 62B, ..., 62N sont identiques aux étapes 300 à 360 décrites précédemment pour le deuxième dispositif avec la référence 62A, et sont réalisées en outre de manière simultanée entre tous les deuxièmes dispositifs 62A, ..., 62N de par la synchronisation temporelle effectuée à l'aide du premier message M1.

Lors de l'étape d'émission 360, le seul deuxième dispositif parmi l'ensemble des deuxièmes dispositifs 62A, ..., 62N autorisé à émettre son deuxième message est le deuxième dispositif dont l'identifiant est contenu dans le premier message M1 reçu lors de l'étape de réception 310 précédente. Le logiciel de distribution 108 détermine selon un ordre croissant les identifiants contenus dans le premier message M1 afin d'attribuer successivement l'unique jeton aux deuxièmes dispositifs 62A, ..., 62N. Autrement dit, chaque deuxième dispositif 62A, ..., 62N émet toutes les N secondes son deuxième message M2A, ..., M2N respectif.

Comme représenté sur la figure 6, lors de l'étape 400, le dispositif de centralisation 64 reçoit, à l'aide de son logiciel de réception 140, le premier message M1 du premier dispositif 60 et le deuxième message du deuxième dispositif autorisé à émettre selon le mécanisme de jeton distribué, par exemple le message M2A.

Lors de l'étape 410, le dispositif de centralisation 64 enregistre ensuite dans sa base de données 88 les valeurs reçues et contenues dans le premier message M1 et dans le deuxième message M2A, par l'intermédiaire de son logiciel d'enregistrement 142. En complément, le logiciel de traitement 144 effectue un horodatage des données enregistrées.

Les grandeurs mesurées et calculées par le système de calcul sont ensuite affichées sur l'écran de l'interface homme-machine 90 du dispositif de centralisation par l'intermédiaire du logiciel d'affichage 146 lors de l'étape 430. Ces grandeurs sont affichées sous forme de valeurs numériques et/ou sous forme de courbes.

Le dispositif de centralisation 64 transmet enfin, lors de l'étape 440 et à l'aide de son logiciel de transmission 148, ces grandeurs mesurées et calculées au serveur distant, non représenté. Le serveur distant est propre à effectuer une gestion centralisée des grandeurs mesurées et calculées pour chaque système de calcul 20.

A l'issue de l'étape 440, le dispositif de centralisation 64 retourne à l'étape 400, afin de recevoir le prochain premier message M1 du premier dispositif et le deuxième message du deuxième dispositif autorisé à émettre la prochaine fois selon le mécanisme de jeton distribué, par exemple le message M2A.

Le système de calcul 20 selon l'invention permet ainsi de calculer les énergies actives $E_1$, $E_2$, $E_3$ directement sur la période d'émission $P_{\text{émission}}$ donnée et en fonction de l'ensemble de grandeurs représentatives de la tension mesurée. Le système de calcul 20 permet en outre, à l'aide de la détermination du coefficient correctif $\sigma_i$, de prendre en compte la contribution des valeurs de la tension mesurée pour toutes les périodes de tension $P_{\text{tension}}$ au cours d'une période d'émission $P_{\text{émission}}$ donnée à partir du moment où le seuil $\varepsilon$ est dépassé, et pas seulement la contribution des valeurs de la tension mesurée pour la période de tension sélectionnée d'indice $k_0$.

Le système de calcul 20 selon l'invention est ainsi plus précis que le système de calcul de l'état de la technique.

Le système de calcul 20 selon l'invention permet en outre d'obtenir une mesure très précise des énergies actives $E_1$, $E_2$, $E_3$ pour les trois phases du courant triphasé, de par la synchronisation temporelle de chaque capteur de courant 76A par rapport à l'organe de mesure de la tension 66.

La synchronisation temporelle est très précise, le décalage de synchronisation mesuré étant de l'ordre de plus ou moins 400 nanosecondes avec la technologie actuelle des émetteurs-récepteurs radioélectriques 70, 80A, ..., 80N, 92 et des unités de traitement d'information 68, 78A, ..., 78N, 86.

L'ensemble des dispositifs 60, 62A, ..., 62N, 64 sont reliés entre eux par des liaisons radioélectriques par l'intermédiaire de leur émetteur-récepteur radioélectrique 70, 82A, ..., 82N, 92 respectif, ce qui permet de faciliter l'installation du système de calcul 20 dans le poste de transformation 10.

La compression des données relatives aux tensions et aux intensités mesurées à l'aide des logiciels de détermination 104, 124A, ..., 124N et l'émission, via le premier message M1, de l'ensemble de grandeurs représentatives associées à la tension mesurée, en lieu et place de coefficients associés à la tension pour toutes les périodes de tension au cours de la période d'émission donnée, permet de limiter la quantité de données transmises via les liaisons radioélectriques, et de limiter ainsi la propre consommation d'énergie du système de calcul 20. Ceci permet en outre de réduire la sensibilité du système de calcul 20 à des perturbations radioélectriques de type brouillage ou perturbation de compatibilité électromagnétique, également appelée perturbation CEM.

Le système de calcul 20 selon un deuxième mode de réalisation de l'invention va être à présent décrit. Pour ce deuxième mode de réalisation, les éléments identiques au premier mode de réalisation, décrit précédemment, sont repérés par des références identiques, et ne sont pas décrits à nouveau.

Selon ce deuxième mode de réalisation, le deuxième logiciel de détermination 106 est en outre propre à déterminer, pour la ou chaque phase, un écart angulaire $\alpha_i$ en fonction d'un ratio pour au moins une période de tension $P_{\text{tension}}$, le ratio étant égal au coefficient imaginaire du fondamental d'une décomposition en série de Fourier de la tension sur ladite période de tension $P_{\text{tension}}$ divisé par le coefficient réel dudit fondamental de la tension.

Cet écart angulaire $\alpha_i$ permet alors de prendre en compte une éventuelle variation de la valeur de la période de tension $P_{\text{tension}}$ telle que les fenêtres d'échantillonnage seraient alors légèrement décalées par rapport à la valeur exacte de de la période de tension P$_{tension}$.

Le logiciel de calcul 123A est alors propre à calculer les énergies actives E$_i$ en fonction en outre de l'écart angulaire α$_i$.

L'écart angulaire α$_i$ vérifie, par exemple, pour la ou chaque phase d'indice i, les équations suivantes :

$$\alpha_i = \frac{1}{K-1} \sum_{k=1}^{K-1} \alpha_{i,k} \text{ et } \alpha_{i,k} = \varphi_i(k+1) - \varphi_i(k) \quad \forall k \in [1; K-1] \tag{16}$$

soit

$$\alpha_i = \frac{\varphi_i(K) - \varphi_i(1)}{K-1} \tag{17}$$

avec

$$\varphi_i(k) = \arctan\left(\frac{\text{Im}\, U_{i,1,k}}{\text{Re}\, U_{i,1,k}}\right) \tag{18}$$

où i est l'indice de la phase correspondante,

k est l'indice de la période de tension P$_{tension}$, avec k compris entre 1 et K, K étant égal au nombre de périodes de tension P$_{tension}$ pendant une période d'émission P$_{émission}$, et

U$_{i,1,k}$ représente le fondamental de la tension pour la phase d'indice i et la période de tension d'indice k.

Selon le deuxième mode de réalisation, le logiciel de calcul 123A calcule alors les coefficients réel et imaginaire d'une décomposition en série de Fourier de la tension, puis les puissances actives, de la manière suivante et selon l'indice k de la période de tension P$_{tension}$.

Selon le deuxième mode de réalisation, la période de tension P$_{tension}$ sélectionnée est la période d'indice égal à 2, et la valeur de l'indice k$_0$ est alors égale à 2.

Pour la période P$_{tension}$ d'indice k égal à 2, les coefficients réel et imaginaire sont égaux aux coefficients complexes modifiés Re$U_{i,j}$ et Im$U_{i,j}$ contenus dans le premier message M1 reçu, et vérifient alors les équations suivantes :

$$\begin{aligned} \text{Re}\, U_{i,j,2} &= \text{Re}\, U_{i,j} \\ \text{Im}\, U_{i,j,2} &= \text{Im}\, U_{i,j} \end{aligned} \tag{19}$$

La puissance active P$_{i,j,2}$ pour chaque phase numéro i, i étant égal à 1, 2 ou 3, et pour chaque rang j compris entre 1 et J, est alors calculée à l'aide de l'équation suivante :

$$P_{i,j,2} = \frac{\left[\text{Re}\, U_{i,j,2} \times \text{Re}\, I_{iA,j,2} + \text{Im}\, U_{i,j,2} \times \text{Im}\, I_{iA,j,2}\right]}{2} \tag{20}$$

Pour les périodes P$_{tension}$ d'indice k variant entre 3 et K, les coefficients réel et imaginaire vérifient les équations suivantes :

$$\begin{aligned} \text{Re}\, U_{i,j,k} &= \cos(j \times \alpha_i) \times \text{Re}\, U_{i,j,k-1} - \sin(j \times \alpha_i) \times \text{Im}\, U_{i,j,k-1} \\ \text{Im}\, U_{i,j,k} &= \cos(j \times \alpha_i) \times \text{Im}\, U_{i,j,k-1} + \sin(j \times \alpha_i) \times \text{Re}\, U_{i,j,k-1} \end{aligned} \tag{21}$$

La puissance active P$_{i,j,k}$ avec l'indice k variant entre 3 et K, et pour chaque phase numéro i, i étant égal à 1, 2 ou 3, et pour chaque rang j compris entre 1 et J, est alors calculée à l'aide de l'équation suivante :

$$P_{i,j,k} = \frac{\left\lfloor \mathrm{Re}\,U_{i,j,k} \times \mathrm{Re}\,I_{iA,j,k} + \mathrm{Im}\,U_{i,j,k} \times \mathrm{Im}\,I_{iA,j,k} \right\rfloor}{2} \qquad (22)$$

Enfin, pour la période de tension d'indice k égal à 1, les coefficients réel et imaginaire vérifient les équations suivantes :

$$\mathrm{Re}\,U_{i,j,1} = \cos(-j \times \alpha_i) \times \mathrm{Re}\,U_{i,j,2} - \sin(-j \times \alpha_i) \times \mathrm{Im}\,U_{i,j,2}$$
$$\mathrm{Im}\,U_{i,j,1} = \cos(-j \times \alpha_i) \times \mathrm{Im}\,U_{i,j,2} + \sin(-j \times \alpha_i) \times \mathrm{Re}\,U_{i,j,2} \qquad (23)$$

De manière analogue, la puissance active $P_{i,j,1}$ pour la période de tension d'indice k égal à 1, pour chaque phase numéro i, i étant égal à 1, 2 ou 3, et pour chaque rang j compris entre 1 et J, est alors calculée à l'aide de l'équation suivante :

$$P_{i,j,1} = \frac{\left\lfloor \mathrm{Re}\,U_{i,j,1} \times \mathrm{Re}\,I_{iA,j,1} + \mathrm{Im}\,U_{i,j,1} \times \mathrm{Im}\,I_{iA,j,1} \right\rfloor}{2} \qquad (24)$$

Le logiciel de calcul 123A calcule ensuite l'énergie active $E_i$ de chaque phase numéro i à l'aide des équations (13) et (14) décrites précédemment.

Les autres étapes du procédé de calcul selon le deuxième mode de réalisation sont identiques à celles décrites précédemment pour le premier mode de réalisation, et ne sont pas décrites à nouveau.

Les avantages de ce deuxième mode de réalisation comportent notamment les avantages du premier mode de réalisation, et ceux-ci ne sont pas décrits à nouveau.

Le système de calcul 20 selon ce deuxième mode de réalisation permet en outre, à l'aide de la détermination de l'écart angulaire $\alpha_i$, de compenser une éventuelle variation de la valeur de la période de tension $P_{tension}$ qui entraînerait un décalage des fenêtres d'échantillonnage par rapport à la valeur exacte de de la période de tension $P_{tension}$.

Le système de calcul 20 selon l'invention est ainsi encore plus précis.

Dans le deuxième mode de réalisation décrit précédemment, pour la période $P_{tension}$ d'indice k égal à 2, les coefficients réel et imaginaire sont choisis égaux aux coefficients complexes modifiés $\mathrm{Re}\,U_{i,j}$ et $\mathrm{Im}\,U_{i,j}$ contenus dans le premier message M1 reçu. Autrement dit, le deuxième mode de réalisation décrit précédemment met en oeuvre à la fois la détermination du coefficient correctif $\sigma_i$ et la détermination de l'écart angulaire $\alpha_i$.

L'homme du métier comprendra qu'en variante la détermination de l'écart angulaire $\alpha_i$ est susceptible d'être mise en oeuvre indépendamment de la détermination du coefficient correctif $\sigma_i$. Le cas échéant, pour la période $P_{tension}$ d'indice k égal à 2, les coefficients réel et imaginaire sont choisis égaux aux coefficients complexes $\mathrm{Re}\,U_{i,j,k0}$ et $\mathrm{Im}\,U_{i,j,k0}$ contenus dans le premier message M1 reçu, avec l'indice $k_0$ égal à 2.

Dans les différents exemples de réalisation, chaque deuxième dispositif 62A, .., 62N comporte l'organe de calcul, par exemple sous la forme du logiciel de calcul 123A, .., 123N. En variante, le logiciel de calcul 123A est apte à être stocké dans un dispositif autre que le deuxième dispositif 62A, tel que par exemple dans le dispositif de centralisation 64. Le calcul des énergies actives $E_1$, $E_2$, $E_3$ est alors effectué à partir des informations relatives aux tensions et aux intensités contenues dans les différents messages reçus par le dispositif de centralisation 64, de la part du premier dispositif 60 et de chaque deuxième dispositif 62A, .., 62N, à savoir le premier message M1 et respectivement les deuxièmes messages M2A, ..., M2N.

Selon un autre mode de réalisation, non représenté, le premier dispositif 60 et le dispositif de centralisation 64 sont regroupés dans un même dispositif commun, ce qui permet d'avoir un unique émetteur-récepteur radioélectrique pour ledit dispositif commun en lieu et place des deux émetteurs-récepteurs radioélectriques 70, 92 du premier dispositif et du dispositif de centralisation.

On conçoit ainsi que le système de calcul 20 selon l'invention est plus précis que le système de calcul de l'état de la technique.

**Revendications**

1. Système (20) de calcul de l'énergie électrique ($E_i$) d'un courant alternatif circulant dans au moins un conducteur électrique secondaire (42A, 44A, 46A, ..., 42N, 44N, 46N), le conducteur secondaire (42A, ..., 46N) étant relié électriquement à un conducteur électrique primaire (34 ; 36 ; 38), le conducteur primaire (34 ; 36 ; 38) et le ou chaque conducteur secondaire (42A, ..., 46N) présentant sensiblement la même tension alternative (U1 ; U2 ; U3), le courant alternatif comportant au moins une phase, ce système de calcul comprenant :

- un premier dispositif (60) comportant un émetteur radioélectrique (70), un organe (66) de mesure de la tension du conducteur primaire (34, 36, 38), des premiers moyens (103) d'échantillonnage de la valeur de la tension mesurée (U1, U2, U3), des moyens (105) d'émission suivant une période d'émission ($P_{émission}$) d'un premier message (M1), la période d'émission ($P_{émission}$) correspondant à un multiple de périodes de tension ($P_{tension}$), la période de tension ($P_{tension}$) étant égale à l'inverse de la fréquence (F) de la tension alternative (U1 ; U2 ; U3), et des moyens (106) de détermination d'un ensemble d'au moins une grandeur représentative de la tension mesurée, ledit ensemble étant déterminé en fonction de la valeur de la tension mesuré pendant une période d'émission donnée ($P_{émission}$), le premier message (M1) contenant ledit ensemble ;
- au moins un deuxième dispositif (62A, ..., 62N) comportant un capteur (76A, ..., 76N) de l'intensité (I1A, ..., I3N) du courant circulant dans le conducteur secondaire correspondant (42A, ..., 46N), des seconds moyens (119A, ..., 119N) d'échantillonnage de la valeur de l'intensité mesurée (I1A, ..., I3N) ; et
- au moins un organe (123A, ..., 123N) de calcul de l'énergie électrique ($E_i$) pour la ou chaque phase dudit courant circulant dans le conducteur secondaire correspondant (42A, ..., 46N), l'organe de calcul étant relié à au moins un deuxième dispositif correspondant (62A, ..., 62N) et comportant un récepteur radioélectrique (80A, ..., 80N) et des moyens de réception du premier message (M1), le ou chaque organe de calcul (123A, ..., 123N) étant propre à calculer une valeur de l'énergie électrique ($E_i$) pendant la période d'émission donnée ($P_{émission}$) en fonction dudit ensemble contenu dans le premier message (M1) et des échantillons de l'intensité associés à la période d'émission donnée ($P_{émission}$),

**caractérisé en ce que** les moyens de détermination (106) sont propres à déterminer ledit ensemble en fonction en outre d'un coefficient correctif ($\sigma_i$) associé à la période d'émission donnée ($P_{émission}$), le coefficient correctif ($\sigma$) étant, pour la ou chaque phase, fonction d'une valeur représentative de la tension ($U_i$) seulement pour chaque période de tension correspondante ($P_{tension}$) où ladite valeur représentative est supérieure à un seuil prédéterminé ($\varepsilon$), la valeur représentative de la tension étant la valeur du module du fondamental d'une décomposition en série de Fourier de la tension ($\|U_{i,1,k}\|$).

2. Système (20) selon la revendication 1, dans lequel le coefficient correctif ($\sigma_i$) vérifie, pour la ou chaque phase, l'équation suivante :

$$\sigma_i = \frac{1}{k_{max}} \times \sum_{\forall k\, /\, \|U_{i,1,k}\| \geq \varepsilon} \frac{\|U_{i,1,k}\|}{\|U_{i,1,k_0}\|}$$

où i est un indice de la phase correspondante,

k est un indice de la période de tension ($P_{tension}$), avec k compris entre 1 et K, K étant égal au nombre de périodes de tension ($P_{tension}$) pendant une période d'émission ($P_{émission}$),

$k_0$ est l'indice d'une période de tension sélectionnée parmi la pluralité de périodes de tension ($P_{tension}$),

$k_{max}$ est le nombre de périodes de tension pour lesquelles la valeur du module du fondamental de la décomposition en série de Fourier de la tension est supérieure au seuil prédéterminé $\varepsilon$ pendant la période d'émission donnée ($P_{émission}$), et

$\|U_{i,1,k}\|$, respectivement $\|U_{i,1,k_0}\|$, représente le module du fondamental de la décomposition en série de Fourier de la tension pour la phase d'indice i et la période de tension d'indice k, respectivement la période de tension sélectionnée d'indice $k_0$.

3. Système (20) selon l'une quelconque des revendications précédentes, dans lequel ledit ensemble d'au moins une grandeur représentative comporte une pluralité de coefficients réel et imaginaire d'une décomposition en série de Fourier de la tension mesurée, le nombre (J) de rangs de la décomposition en série de Fourier étant de préférence supérieur ou égal à 5, de préférence encore égal à 17.

4. Système (20) selon la revendication 3, dans lequel l'énergie électrique ($E_i$) vérifie, pour la ou chaque phase, les équations suivantes :

$$E_i = \sum_{j=1}^{J} E_{i,j} \qquad \text{et} \qquad E_{i,j} = \sum_{k=1}^{K} P_{i,j,k} \times P_{émission}$$

où i est un indice de la phase correspondante,
j est un rang de la décomposition en série de Fourier, avec j compris entre 1 et J, J étant égal au nombre de rangs de ladite décomposition, le fondamental correspondant au rang égal à 1,
k est un indice de la période de tension ($P_{tension}$) correspondante, avec k compris entre 1 et K, K étant égal au nombre de périodes de tension ($P_{tension}$) pendant une période d'émission ($P_{émission}$), et
$P_{i,j,k}$ représente la puissance active pour la phase d'indice i, les coefficients réel et imaginaire de rang j et la période de tension d'indice k.

5. Système (20) selon l'une quelconque des revendications précédentes, dans lequel les moyens de détermination (106) sont en outre propres à déterminer, pour la ou chaque phase, un écart angulaire ($\alpha_i$) en fonction d'un ratio pour au moins une période de tension ($P_{tension}$), le ratio étant égal au coefficient imaginaire du fondamental ($ImU_{i,1,k}$) d'une décomposition en série de Fourier de la tension sur ladite période de tension ($P_{tension}$) divisé par le coefficient réel dudit fondamental de la tension ($ReU_{i,1,k}$), et l'organe de calcul (123A, ..., 123N) est propre à calculer une valeur de l'énergie électrique ($E_i$) en fonction en outre de l'écart angulaire ($\alpha_i$).

6. Système (20) selon la revendication 5, dans lequel l'écart angulaire ($\alpha_i$) est déterminé, pour la ou chaque phase, à l'aide des équations suivantes :

$$\alpha_i = \frac{1}{K-1} \sum_{k=1}^{K-1} \alpha_{i,k} \ \text{ et } \ \alpha_{i,k} = \varphi_i(k+1) - \varphi_i(k) \quad \forall k \in \left[1; K-1\right]$$

soit

$$\alpha_i = \frac{\varphi_i(K) - \varphi_i(1)}{K-1} \ \text{ avec } \ \varphi_i(k) = \arctan\left(\frac{Im\,U_{i,1,k}}{Re\,U_{i,1,k}}\right)$$

où i est un indice de la phase correspondante,
k est un indice de la période de tension ($P_{tension}$), avec k compris entre 1 et K, K étant égal au nombre de périodes de tension ($P_{tension}$) pendant une période d'émission ($P_{émission}$); et
$U_{i,1,k}$ représente le fondamental de la tension pour la phase d'indice i et la période de tension d'indice k.

7. Système (20) selon la revendication 5 ou 6, dans lequel les premiers coefficients réel ($ReU_{i,j,k}$) et imaginaire ($ImU_{i,j,k}$) d'une décomposition en série de Fourier de la tension mesurée sont calculés à l'aide des équations suivantes, pour chaque période de tension présentant un indice (k) compris entre 3 et K, la période de tension sélectionnée ayant un indice ($k_0$) égal à 2 :

$$Re\,U_{i,j,k} = \cos(j \times \alpha_i) \times Re\,U_{i,j,k-1} - \sin(j \times \alpha_i) \times Im\,U_{i,j,k-1}$$

$$Im\,U_{i,j,k} = \cos(j \times \alpha_i) \times Im\,U_{i,j,k-1} + \sin(j \times \alpha_i) \times Re\,U_{i,j,k-1}$$

et dans lequel les premiers coefficients réel et imaginaire d'une décomposition en série de Fourier de la tension mesurée sont calculés à l'aide des équations suivantes, pour la période de tension d'indice (k) égal à 1 :

$$Re\,U_{i,j,1} = \cos(-j \times \alpha_i) \times Re\,U_{i,j,2} - \sin(-j \times \alpha_i) \times Im\,U_{i,j,2}$$

$$Im\,U_{i,j,1} = \cos(-j \times \alpha_i) \times Im\,U_{i,j,2} + \sin(-j \times \alpha_i) \times Re\,U_{i,j,2}.$$

**8.** Armoire électrique, comprenant :

- un tableau (16) comportant au moins un conducteur électrique primaire de départ (34, 36, 38) et au moins un conducteur électrique secondaire de départ (42A, ..., 46N), le ou chaque conducteur secondaire de départ (42A, ..., 46N) étant connecté électriquement à un conducteur primaire de départ (34 ; 36 ; 38) correspondant, les conducteurs de départ (34, 42A, 42B, .., 38, 46A, 46B, ..., 46N) correspondants présentant une tension alternative, et
- un système (20) de calcul de l'énergie électrique (Ei) d'un courant circulant dans le ou chaque conducteur secondaire de départ (42A, ..., 46N),

**caractérisé en ce que** le système de calcul (20) est conforme à l'une quelconque des revendications précédentes.

**9.** Poste (10) de transformation d'un courant électrique présentant une première tension alternative en un courant électrique présentant une deuxième tension alternative,

**caractérisé en ce qu'**il comprend une armoire électrique selon la revendication 8, un tableau d'arrivée (14) comportant au moins un conducteur électrique d'arrivée (24A, 26A, 28A, 24B, 26B, 28B) propre à être relié à un réseau électrique (12), le conducteur d'arrivée présentant la première tension alternative, le tableau (16) de l'armoire formant un tableau de départ dont les conducteurs de départ (34, 42A, 42B, .., 38, 46A, 46B, ..., 46N) correspondants présentent la deuxième tension alternative, et

un transformateur électrique (18) connecté entre le tableau d'arrivée (14) et le tableau de départ (16), le transformateur (18) étant propre à transformer le courant présentant la première tension alternative en le courant présentant la deuxième tension alternative.

**10.** Procédé de calcul de l'énergie électrique ($E_i$) d'un courant alternatif circulant dans au moins un conducteur électrique secondaire (42A, 44A, 46A, 42B, 44B, 46B, ..., 42N, 44N, 46N), le conducteur secondaire (42A, ..., 46N) étant relié électriquement à un conducteur électrique primaire (34 ; 36 ; 38), le conducteur primaire (34 ; 36 ; 38) et le ou chaque conducteur secondaire (42A, ..., 46N) présentant sensiblement la même tension alternative, le courant alternatif comportant au moins une phase,
le procédé comprenant les étapes suivantes :

- (a) la mesure (210), par un premier dispositif (60), de la tension (U1, U2, U3) du courant circulant dans le conducteur primaire (34, 36, 38), l'échantillonnage de la valeur de la tension mesurée (U1, U2, U3), la détermination (220) d'un ensemble d'au moins une grandeur représentative de la tension mesurée, ledit ensemble étant déterminé en fonction de la valeur de la tension mesurée pendant la période d'émission donnée ($P_{\text{émission}}$), le premier message (M1) contenant ledit ensemble, et l'émission (230) suivant une période d'émission ($P_{\text{émission}}$) d'un premier message (M1), la période d'émission ($P_{\text{émission}}$) correspondant à un multiple de périodes de tension ($P_{\text{tension}}$), la période de tension ($P_{\text{tension}}$) étant égale à l'inverse de la fréquence de la tension alternative (U1 ; U2 ; U3),
- (b) la mesure (330), par un deuxième dispositif (62A, ..., 62N), de l'intensité (I1, ..., I3N) du courant circulant dans le conducteur secondaire (42A, ..., 46N) correspondant, et l'échantillonnage de la valeur de l'intensité mesurée (I1A, ..., I3N), et
- (c) le calcul (340), par au moins un organe de calcul (123A, ..., 123N), de l'énergie électrique ($E_i$) pour la ou chaque phase dudit courant circulant dans le conducteur secondaire (42A, ..., 46N) correspondant, l'organe de calcul étant relié à au moins un deuxième dispositif correspondant (62A, ..., 62N) et comportant un récepteur radioélectrique (80A, ..., 80N) et des moyens de réception du premier message (M1), le calcul de l'énergie électrique (Ei) étant effectué en fonction dudit ensemble contenu dans le premier message (M1) et des échantillons de l'intensité associés à la période d'émission donnée ($P_{\text{émission}}$),

**caractérisé en ce que**, lors de l'étape (a), ledit ensemble est déterminé en fonction en outre d'un coefficient correctif ($\sigma_i$) associé à la période d'émission donnée ($P_{\text{émission}}$), le coefficient correctif ($\sigma$) étant, pour la ou chaque phase, fonction d'une valeur représentative de la tension ($U_i$) seulement pour chaque période de tension correspondante ($P_{\text{tension}}$) où ladite valeur représentative est supérieure à un seuil prédéterminé ($\varepsilon$), la valeur représentative de la tension étant la valeur du module du fondamental d'une décomposition en série de Fourier de la tension ($\|U_{i,1,k}\|$).

**Patentansprüche**

**1.** System (20) zum Berechnen der elektrischen Energie ($E_i$) eines Wechselstroms, der in mindestens einem sekundären elektrischen Leiter (42A, 44A, 46A, ..., 42N, 44N, 46N) fließt, wobei der sekundäre Leiter (42A, ..., 46N) mit einem primären elektrischen Leiter (34; 36; 38) elektrisch verbunden ist, wobei der primäre Leiter (34; 36; 38) und der oder jeder sekundäre Leiter (42A, ..., 46N) im Wesentlichen dieselbe Wechselspannung (U1; U2; U3) aufweisen, wobei der Wechselstrom mindestens eine Phase umfasst,

wobei dieses Rechensystem umfasst:

- eine erste Vorrichtung (60) mit einem Funksender (70), einer Einrichtung (66) zum Messen der Spannung des primären Leiters (34, 36, 38), ersten Mitteln (103) zum Abtasten des Werts der gemessenen Spannung (U1, U2, U3), Mitteln (105) zum Senden einer ersten Nachricht (M1) gemäß einer Sendeperiode ($P_{Sendung}$), wobei die Sendeperiode ($P_{Sendung}$) einem Vielfachen von Spannungsperioden ($P_{Spannung}$) entspricht, wobei die Spannungsperiode ($P_{Spannung}$) gleich dem Kehrwert der Frequenz (F) der Wechselspannung (U1; U2; U3) ist, und Mitteln (106) zum Bestimmen einer Einheit mindestens einer repräsentativen Größe der gemessenen Spannung, wobei die Einheit in Abhängigkeit vom Wert der gemessenen Spannung während einer gegebenen Sendeperiode ($P_{Sendung}$) bestimmt wird, wobei die erste Nachricht (M1) die Einheit enthält;
- mindestens eine zweite Vorrichtung (62A, ..., 62N) mit einem Sensor (76A, ..., 76N) für die Intensität (I1A, ..., I3N) des Stroms, der im entsprechenden sekundären Leiter (42A, ..., 46N) fließt, zweiten Mitteln (119A, ..., 119N) zum Abtasten des Werts der gemessenen Intensität (I1A, ..., I3N); und
- mindestens eine Einrichtung (123A, ..., 123N) zum Berechnen der elektrischen Energie ($E_i$) für die oder jede Phase des Stroms, der im entsprechenden sekundären Leiter (42A, ..., 46N) fließt, wobei die Recheneinrichtung mit mindestens einer zweiten entsprechenden Vorrichtung (62A, ..., 62N) verbunden ist und einen Funkempfänger (80A, ..., 80N) und Mittel zum Empfangen der ersten Nachricht (M1) umfasst, wobei die oder jede Recheneinrichtung (123A, ..., 123N) geeignet ist, um einen Wert der elektrischen Energie ($E_i$) während der gegebenen Sendeperiode ($P_{Sendung}$) in Abhängigkeit von der Einheit, die in der ersten Nachricht (M1) enthalten ist, und den Abtastwerten der Intensität, die der gegebenen Sendeperiode ($P_{Sendung}$) zugeordnet sind, zu berechnen,

**dadurch gekennzeichnet, dass** die Bestimmungsmittel (106) geeignet sind, um die Einheit außerdem in Abhängigkeit von einem Korrekturkoeffizienten ($\sigma_i$) zu bestimmen, der der gegebenen Sendeperiode ($P_{Sendung}$) zugeordnet ist, wobei der Korrekturkoeffizient ($\sigma_i$) für die oder jede Phase eine Funktion eines repräsentativen Werts der Spannung ($U_i$) nur für jede entsprechende Spannungsperiode ($P_{Spannung}$) ist, wobei der repräsentative Wert größer ist als ein vorbestimmter Schwellenwert ($\varepsilon$), wobei der repräsentative Wert der Spannung der Wert des Moduls des Grundzustandes einer Fourier-Reihenzerlegung der Spannung ($\|U_{i,1,k}\|$) ist.

2. System (20) nach Anspruch 1, in dem der Korrekturkoeffizient ($\sigma_i$) für die oder jede Phase die folgende Gleichung überprüft:

$$\sigma_i = \frac{1}{k_{max}} \times \sum_{\forall k\,/\,\|U_{i,1,k}\| \geq \varepsilon} \frac{\|U_{i,1,k}\|}{\|U_{i,1,k_0}\|}$$

wobei i ein Index der entsprechenden Phase ist,
k ein Index der Spannungsperiode ($P_{Spannung}$) ist, wobei k zwischen 1 und K liegt, wobei K gleich der Anzahl von Spannungsperioden ($P_{Spannung}$) während einer Sendeperiode ($P_{Sendung}$) ist,
$k_0$ der Index einer aus den mehreren Spannungsperioden ($P_{Spannung}$) ausgewählten Spannungsperiode ist,
$k_{max}$ die Anzahl von Spannungsperioden ist, für die der Wert des Moduls des Grundzustandes der Fourier-Reihenzerlegung der Spannung größer ist als der vorbestimmte Schwellenwert $\varepsilon$ während der gegebenen Sendeperiode ($P_{Sendung}$) und
$\|U_{i,1,k}\|$ bzw. $\|U_{i,1,k_0}\|$ den Modul des Grundzustandes der Fourier-Reihenzerlegung der Spannung für die Phase mit dem Index i und die Spannungsperiode mit dem Index k bzw. die ausgewählte Spannungsperiode mit dem Index $k_0$ darstellen.

3. System (20) nach einem der vorangehenden Ansprüche, in dem die Einheit mindestens einer repräsentativen Größe mehrere reale und imaginäre Koeffizienten einer Fourier-Reihenzerlegung der gemessenen Spannung umfasst, wobei die Anzahl (J) von Rängen der Fourier-Reihenzerlegung vorzugsweise größer als oder gleich 5, vorzugsweise auch gleich 17 ist.

4. System (20) nach Anspruch 3, in dem die elektrische Energie ($E_i$) für die oder jede Phase die folgenden Gleichungen überprüft:

$$E_i = \sum_{j=1}^{J} E_{i,j} \quad \text{und} \quad E_{i,j} = \sum_{k=1}^{K} P_{i,j,k} \times P_{Sendung}$$

wobei i ein Index der entsprechenden Phase ist,
j ein Rang der Fourier-Reihenzerlegung ist, wobei j zwischen 1 und J liegt, wobei J gleich der Anzahl von Rängen der Zerlegung ist, wobei der Grundzustand dem Rang gleich 1 entspricht,
k ein Index der entsprechenden Spannungsperiode ($P_{Spannung}$) ist, wobei k zwischen 1 und K liegt, wobei K gleich der Anzahl von Spannungsperioden ($P_{Spannung}$) während einer Sendeperiode ($P_{Sendung}$) ist, und
$P_{i,j,k}$ die aktive Leistung für die Phase mit dem Index i, die realen und imaginären Koeffizienten des Rangs j und die Spannungsperiode mit dem Index k darstellt.

**5.** System (20) nach einem der vorangehenden Ansprüche, in dem die Bestimmungsmittel (106) außerdem geeignet sind, um für die oder jede Phase einen Winkelabstand ($\alpha_i$) in Abhängigkeit von einem Verhältnis für mindestens eine Spannungsperiode ($P_{Spannung}$) zu bestimmen, wobei das Verhältnis gleich dem imaginären Koeffizienten des Grundzustandes ($ImU_{i,1,k}$) einer Fourier-Reihenzerlegung der Spannung auf der Spannungsperiode ($P_{Spannung}$) dividiert durch den realen Koeffizienten des Grundzustandes der Spannung ($ReU_{i,1,k}$) ist, und die Recheneinrichtung (123A, ..., 123N) geeignet ist, um einen Wert der elektrischen Energie ($E_i$) außerdem in Abhängigkeit vom Winkelabstand ($\alpha_i$) zu berechnen.

**6.** System (20) nach Anspruch 5, in dem der Winkelabstand ($\alpha_i$) für die oder jede Phase mit Hilfe der folgenden Gleichungen bestimmt wird:

$$\alpha_i = \frac{1}{K-1} \sum_{k=1}^{K-1} \alpha_{i,k} \quad \text{und} \quad \alpha_{i,k} = \varphi_i(k+1) - \varphi_i(k) \quad \forall k \in [1; K-1]$$

$$\text{wobei } \alpha_i = \frac{\varphi_i(K) - \varphi_i(1)}{K-1} \text{ mit } \varphi_i(k) = \arctan\left(\frac{Im U_{i,1,k}}{Re U_{i,1,k}}\right)$$

wobei i ein Index der entsprechenden Phase ist,
k ein Index der Spannungsperiode ($P_{Spannung}$) ist, wobei k zwischen 1 und K liegt, wobei K gleich der Anzahl von Spannungsperioden ($P_{Spannung}$) während einer Sendeperiode ($P_{Sendung}$) ist, und
$U_{i,1,k}$ den Grundzustand der Spannung für die Phase mit dem Index i und die Spannungsperiode mit dem Index k darstellt.

**7.** System (20) nach Anspruch 5 oder 6, in dem die ersten realen ($ReU_{i,j,k}$) und imaginären ($ImU_{i,j,k}$) Koeffizienten einer Fourier-Reihenzerlegung der gemessenen Spannung mit Hilfe der folgenden Gleichungen für jede Spannungsperiode berechnet werden, die einen Index (k) zwischen 3 und K aufweist, wobei die ausgewählte Spannungsperiode einen Index ($k_0$) gleich 2 aufweist:

$$Re U_{i,j,k} = \cos(j \times \alpha_i) \times Re U_{i,j,k-1} - \sin(j \times \alpha_i) \times Im U_{i,j,k-1}$$

$$Im U_{i,j,k} = \cos(j \times \alpha_i) \times Im U_{i,j,k-1} + \sin(j \times \alpha_i) \times Re U_{i,j,k-1}$$

und in dem die ersten realen und imaginären Koeffizienten einer Fourier-Reihenzerlegung der gemessenen Spannung mit Hilfe der folgenden Gleichungen für die Spannungsperiode mit dem Index (k) gleich 1 berechnet werden:

$$Re U_{i,j,1} = \cos(-j \times \alpha_i) \times Re U_{i,j,2} - \sin(-j \times \alpha_i) \times Im U_{i,j,2}$$

$$\mathrm{Im}\,U_{i,j,1} = \cos(-j \times \alpha_i) \times \mathrm{Im}\,U_{i,j,2} + \sin(-j \times \alpha_i) \times \mathrm{Re}\,U_{i,j,2}\,.$$

8. Schaltschrank, der umfasst:

- eine Schalttafel (16) mit mindestens einem primären elektrischen Ausgangsleiter (34, 36, 38) und mindestens einem sekundären elektrischen Ausgangsleiter (42A, ..., 46N), wobei der oder jeder sekundäre Ausgangsleiter (42A, ..., 46N) mit einem entsprechenden primären Ausgangsleiter (34; 36; 38) elektrisch verbunden ist, wobei die entsprechenden Ausgangsleiter (34, 42A, 42B, ..., 38, 46A, 46B, ..., 46N) eine Wechselspannung aufweisen, und

ein System (20) zum Berechnen der elektrischen Energie (Ei) eines Stroms, der in dem oder jedem sekundären Ausgangsleiter (42A, ..., 46N) fließt,
**dadurch gekennzeichnet, dass** das Rechensystem (20) gemäß einem der vorangehenden Ansprüche ist.

9. Station (10) zur Transformation eines elektrischen Stroms, der eine erste Wechselspannung aufweist, in einen elektrischen Strom, der eine zweite Wechselspannung aufweist,
**dadurch gekennzeichnet, dass** sie einen Schaltschrank nach Anspruch 8, eine Eingangsschalttafel (14) mit mindestens einem elektrischen Eingangsleiter (24A, 26A, 28A, 24B, 26B, 28B), der mit einem elektrischen Netz (12) verbunden werden kann, umfasst, wobei der Eingangsleiter die erste Wechselspannung aufweist, wobei die Schalttafel (16) des Schranks eine Ausgangsschalttafel bildet, deren entsprechende Ausgangsleiter (34, 42A, 42B, ..., 38, 46A, 46B, ..., 46N) die zweite Wechselspannung aufweisen, und
einen elektrischen Transformator (18), der zwischen die Eingangsschalttafel (14) und die Ausgangsschalttafel (16) geschaltet ist, wobei der Transformator (18) geeignet ist, um den Strom, der die erste Wechselspannung aufweist, in den Strom, der die zweite Wechselspannung aufweist, zu transformieren.

10. Verfahren zum Berechnen der elektrischen Energie ($E_i$) eines Wechselstroms, der in mindestens einem sekundären elektrischen Leiter (42A, 44A, 46A, 42B, 44B, 46B, ..., 42N, 44N, 46N) fließt, wobei der sekundäre Leiter (42A, ..., 46N) mit einem primären elektrischen Leiter (34; 36; 38) elektrisch verbunden ist, wobei der primäre Leiter (34; 36; 38) und der oder jeder sekundäre Leiter (42A, ..., 46N) im Wesentlichen dieselbe Wechselspannung aufweisen, wobei der Wechselstrom mindestens eine Phase umfasst,
wobei das Verfahren die folgenden Schritte umfasst:

- (a) die Messung (210) der Spannung (U1, U2, U3) des Stroms, der im primären Leiter (34, 36, 38) fließt, durch eine erste Vorrichtung (60), die Abtastung des Werts der gemessenen Spannung (U1, U2, U3), die Bestimmung (220) einer Einheit von mindestens einer repräsentativen Größe der gemessenen Spannung, wobei die Einheit in Abhängigkeit vom Wert der gemessenen Spannung während der gegebenen Sendeperiode ($P_{Sendung}$) bestimmt wird, wobei die erste Nachricht (M1) die Einheit enthält, und die Sendung (230) einer ersten Nachricht (M1) gemäß einer Sendeperiode ($P_{Sendung}$), wobei die Sendeperiode ($P_{Sendung}$) einem Vielfachen von Spannungsperioden ($P_{Span-nung}$) entspricht, wobei die Spannungsperiode ($P_{Spannung}$) gleich dem Kehrwert der Frequenz der Wechselspannung (U1; U2; U3) ist,
- (b) die Messung (330) der Intensität (I1, ..., I3N) des Stroms, der im entsprechenden sekundären Leiter (42A, ..., 46N) fließt, durch eine zweite Vorrichtung (62A, ..., 62N) und die Abtastung des Werts der gemessenen Intensität (I1A, ..., I3N) und
- (c) die Berechnung (340) der elektrischen Energie ($E_i$) für die oder jede Phase des Stroms, der im entsprechenden sekundären Leiter (42A, ..., 46N) fließt, durch mindestens eine Recheneinrichtung (123A, ..., 123N), wobei die Recheneinrichtung mit mindestens einer zweiten entsprechenden Vorrichtung (62A, ..., 62N) verbunden ist und einen Funkempfänger (80A, ..., 80N) und Mittel zum Empfangen der ersten Nachricht (M1) umfasst, wobei die Berechnung der elektrischen Energie (Ei) in Abhängigkeit von der Einheit, die in der ersten Nachricht (M1) enthalten ist und den Abtastwerten der Intensität, die der gegebenen Sendeperiode ($P_{Sendung}$) zugeordnet sind, durchgeführt wird,

**dadurch gekennzeichnet, dass** in Schritt (a) die Einheit außerdem in Abhängigkeit von einem Korrekturkoeffizienten ($\sigma_i$) bestimmt wird, der der gegebenen Sendeperiode ($P_{Sendung}$) zugeordnet ist, wobei der Korrekturkoeffizient ($\sigma_i$) für die oder jede Phase eine Funktion eines repräsentativen Werts der Spannung ($U_i$) nur für jede entsprechende Spannungsperiode ($P_{Spannung}$) ist, wobei der repräsentative Wert größer ist als ein vorbestimmter Schwellenwert ($\varepsilon$), wobei der repräsentative Wert der Spannung der Wert des Moduls des Grundzustandes einer Fourier-Reihenzerlegung der Spannung ($\|U_{i,1,k}\|$) ist.

**Claims**

1. A computation (20) system for calculating the electrical energy ($E_i$) of an alternating current flowing in at least one secondary electrical conductor (42A, 44A, 46A, ..., 42N, 44N, 46N), the secondary conductor (42A, ..., 46N) being electrically connected to a primary electrical conductor (34; 36; 38), the primary conductor (34, 36, 38) and each secondary conductor (42A, ..., 46N) having substantially the same alternating voltage (U1, U2, U3), the alternating current having at least one phase.
   this computation system including:

   - a first device (60) comprising a radio transmitter (70), a measuring member (66) for measuring the voltage of the primary conductor (34, 36, 38), first sampling means (103) for sampling the value of the measured voltage (U1, U2, U3), message transmitting means (105) for transmitting, following a period of transmission ($P_{transmission}$) of a first message (M1), the transmission period (P transmission) corresponding to a multiple of voltage periods ($P_{voltage}$), the voltage period ($P_{voltage}$) being equal to the inverse of the frequency (F) of the alternating voltage (U1, U2, U3), and voltage determination means (106) for determining a set of at least one variable value representative of the measured voltage, said data set being determined based on the value of the voltage measured during a given transmission period ($P_{transmission}$), with the first message (M1) containing said data set;
   - at least one second device (62A, ..., 62N) comprising a current intensity sensor (76A, ..., 76N) for determining the intensity (I1A, ..., I3N) of the current flowing in the corresponding secondary conductor (42A, ..., 46N), second sampling means (119A, ..., 119N) for sampling the value of the measured intensity; (I1A, ..., I3N); and
   - at least one computing member (123A, ..., 123N) for calculating the electrical energy ($E_i$) for each phase of said current flowing in the corresponding secondary conductor (42A, ..., 46N), the computing member being connected to at least one corresponding second device (62A, ..., 62N) and including a radio receiver (80A, ..., 80N) and message reception means for receiving the first message (M1), each computing member (123A, ... , 123N) being configured for calculating a value for the electrical energy ($E_i$) during the given transmission period (P transmission) on the basis of said data set contained in the first message (M1) and samples of the intensity associated with the given transmission period ($P_{transmission}$),

   **characterised in that** the voltage determination means (106) are configured for determining said data set based further on a correction coefficient ($\sigma_i$) associated with the given transmission period ($P_{transmission}$), the correction coefficient ($\sigma$) being, for each phase, a function of a value representative of the voltage ($U_i$) only for each corresponding voltage period (P voltage) where said representative value is greater than a predetermined threshold value ($\varepsilon$),
   the value representative of the voltage being the value of the modulus of the fundamental of a Fourier series decomposition of the voltage ($\|U_{i,1,k}\|$).

2. A system (20) according to claim 1, wherein the correction coefficient ($\sigma_i$) satisfies, for each phase, the following equation :

$$\sigma_i = \frac{1}{k_{max}} \times \sum_{\forall k\,/\|U_{i,1,k}\|\geq\varepsilon} \frac{\|U_{i,1,k}\|}{\|U_{i,1,k_0}\|}$$

   where i is an index of the corresponding phase,
   k is an index of the voltage period ($P_{voltage}$), with k comprised between 1 and K, K being equal to the number of voltage periods (P voltage) occurring during a transmission period ($P_{transmission}$),
   $k_0$ is the index of a voltage period selected from among the plurality of voltage periods ($P_{voltage}$),
   $k_{max}$ is the number of voltage periods for which the value of the modulus of the fundamental of the Fourier series decomposition of the voltage is greater than the predetermined threshold value $\varepsilon$ during the given transmission period ($P_{transmission}$), and
   $\|U_{i,1,k}\|$ and $\|U_{i,1,k_0}\|$, respectively represent the modulus of the fundamental of the Fourier series decomposition of the voltage for the phase having index i and the voltage period having index k, and respectively the selected voltage period having index $k_0$.

3. A system (20) according to any one of the preceding claims, wherein said set of at least one representative variable value has a plurality of real and imaginary coefficients of a Fourier series decomposition of the measured voltage, the number (J) of rows of the Fourier series decomposition preferably being greater than or equal to 5, more preferably equal to 17.

4. A system (20) according to claim 3, wherein the electrical energy ($E_i$) satisfies, for each phase, the following equations :

$$E_i = \sum_{j=1}^{J} E_{i,j}$$

and

$$E_{i,j} = \sum_{k=1}^{K} P_{i,j,k} \times P_{transmission}$$

where i is an index of the corresponding phase,
j is a row of the Fourier series decomposition, with j between 1 and J, J being equal to the number of rows of said decomposition, the fundamental corresponding to the row that is equal to 1,
k is an index of the corresponding voltage period ($P_{voltage}$), with k between 1 and K, K being equal to the number of voltage periods ($P_{voltage}$) occurring during a transmission period ($P_{transmission}$), and
$P_{i,j,k}$ represents the active power for the phase having index i, the real and imaginary coefficients of row j and the voltage period having index k.

5. A system (20) according to any one of the preceding claims, wherein the measured voltage determination means (106) are in addition configured for determining, for each phase, an angular deviation ($\alpha_i$) based on a ratio for at least one voltage period ($P_{voltage}$), the ratio being equal to the imaginary coefficient of the fundamental ($ImU_{i,1,k}$) of a Fourier series decomposition of the voltage over said voltage period ($P_{voltage}$) divided by the real coefficient of said fundamental of the voltage ($ReU_{i,1,k}$), and the computing member (123A, ..., 123N) is configured for calculating a value for the electrical energy ($E_i$) based furthermore on the angular deviation ($\alpha_i$).

6. A system (20) according to claim 5, wherein the angular deviation ($\alpha_i$) is determined, for each phase, via the following equations:

$$\alpha_i = \frac{1}{K-1}\sum_{k=1}^{K-1} \alpha_{i,k} \text{ and } \alpha_{i,k} = \varphi_i(k+1) - \varphi_i(k) \quad \forall k \in \left[1; K-1\right]$$

that is $\alpha_i = \dfrac{\varphi_i(K) - \varphi_i(1)}{K-1}$ with $\varphi_i(k) = \arctan\left(\dfrac{ImU_{i,1,k}}{ReU_{i,1,k}}\right)$

where i is an index of the corresponding phase,
k is an index of the voltage period ($P_{voltage}$), with k comprised between 1 and K, K being equal to the number of voltage periods ($P_{voltage}$) occurring during a transmission period ($P_{transmission}$), and
$U_{i,1,k}$ represents the fundamental of the voltage for the phase having index i and the voltage period having index k.

7. A system (20) according to claim 5 or 6, wherein the first real coefficient ($ReU_{i,j,k}$) and imaginary coefficient ($ImU_{i,j,k}$) of a Fourier series decomposition of the measured voltage are calculated via the following equations, for each voltage period having an index (k) comprised between 3 and K, the selected voltage period having an index ($k_0$) equal to 2 :

$$ReU_{i,j,k} = \cos(j \times \alpha_i) \times ReU_{i,j,k-1} - \sin(j \times \alpha_i) \times ImU_{i,j,k-1}$$

$$\mathrm{Im}\,U_{i,j,k} = \cos(j \times \alpha_i) \times \mathrm{Im}\,U_{i,j,k-1} + \sin(j \times \alpha_i) \times \mathrm{Re}\,U_{i,j,k-1}$$

and wherein the first real and imaginary coefficients of a Fourier series decomposition of the measured voltage are calculated via the following equations, for the voltage period having index (k) equal to 1 :

$$\mathrm{Re}\,U_{i,j,1} = \cos(-j \times \alpha_i) \times \mathrm{Re}\,U_{i,j,2} - \sin(-j \times \alpha_i) \times \mathrm{Im}\,U_{i,j,2}$$

$$\mathrm{Im}\,U_{i,j,1} = \cos(-j \times \alpha_i) \times \mathrm{Im}\,U_{i,j,2} + \sin(-j \times \alpha_i) \times \mathrm{Re}\,U_{i,j,2}\,.$$

8. An electrical cabinet, comprising:

    - a panel (16) including at least one primary output electrical conductor (34, 36, 38) and at least one secondary output electrical conductor (42A, ..., 46N), each secondary output conductor (42A, ..., 46N) being electrically connected to a corresponding primary output conductor (34; 36; 38), the corresponding output conductors (34, 42A, 42B, .., 38, 46A, 46B, ..., 46N) having an alternating voltage, and
    - a computation system (20) for calculating the electric energy (Ei) of a current flowing in each secondary output conductor (42A, ..., 46N),

    **characterised in that** the computation system (20) is in accordance with any one of the preceding claims.

9. A transformer substation (10) for transformation of an electric current having a first alternating voltage into an electric current having a second alternating voltage,
    **characterised in that** it includes an electrical cabinet according to claim 8, an input panel (14) including at least one input electrical conductor (24A, 26A, 28A, 24B, 26B, 28B) configured for being connected to an electrical network (12), the input electrical conductor having the first alternating voltage, the panel (16) of the electrical cabinet forming an output panel wherein the corresponding output conductors (34, 42A, 42B, .., 38, 46A, 46B, ..., 46N) have the second alternating voltage, and
    an electrical transformer (18) connected between the input panel (14) and the output panel (16), the transformer (18) being configured for transforming the current having the first alternating voltage into the current having the second alternating voltage.

10. A method for calculating the electric energy ($E_i$) of an alternating current flowing in at least one secondary electrical conductor (42A, 44A, 46A, 42B, 44B, 46B, ..., 42N, 44N, 46N), the secondary conductor (42A, ..., 46N) being electrically connected to a primary electrical conductor (34; 36; 38), the primary conductor (34; 36; 38) and each secondary conductor (42A, ..., 46N) having substantially the same alternating voltage, the alternating current having at least one phase,
    the method including the following steps:

    - (a) measuring (210), by a first device (60), of the voltage (U1, U2, U3) of the current flowing in the primary conductor (34, 36, 38), sampling of the value of the measured voltage (U1, U2, U3), determination (220) of a set of at least one variable value representative of the measured voltage, said data set being determined based on the value of the voltage measured during a given transmission period ($P_{transmission}$), with the first message (M1) containing said data set, and transmitting (230) following a period of transmission ($P_{transmission}$) of a first message (M1), the transmission period ($P_{transmission}$) corresponding to a multiple of voltage periods ($P_{voltage}$), the voltage period ($P_{voltage}$) being equal to the inverse of the frequency of the alternating voltage (U1 ; U2 ; U3),
    - (b) measuring (330), by a second device (62A, ..., 62N), of the intensity (11, ..., I3N) of the current flowing in the corresponding secondary conductor (42A, ..., 46N), and sampling of the value of the measured intensity (I1A, ..., I3N), and
    - (c) calculation (340) by at least one computing member (123A, ..., 123N), of the electrical energy ($E_i$) for each phase of said current flowing in the corresponding secondary conductor (42A, ..., 46N), the computing member being connected to at least one corresponding second device (62A, ..., 62N) and including a radio receiver (80A, ..., 80N) and the message reception means for receiving the first message (M1), the calculation of the electric energy (Ei) being performed on the basis of said data set contained in the first message (M1) and samples of the intensity associated with the given transmission period ($P_{transmission}$),

**characterised in that**, during the step (a), said data set is determined based further on a correction coefficient ($\sigma_i$) associated with the given transmission period ($P_{transmission}$), the correction coefficient ($\sigma$) being, for each phase, a function of a value representative of the voltage ($U_i$) only for each corresponding voltage period (P voltage) where said representative value is greater than a predetermined threshold value ($\varepsilon$), the value representative of the voltage being the value of the modulus of the fundamental of a Fourier series decomposition of the voltage ($\|U_{i,1,k}\|$).

FIG.1

FIG.2

FIG.3

```
            ┌─────────────────────────────────────┐    ⌇  200
            │  Initialisation et mesure de la fréquence │
            └─────────────────────────────────────┘
                          │         │
            ┌─────────────▼─────────▼─────────────┐      210
            │          Mesure de la tension         │
            └─────────────────────────────────────┘
                          │
            ┌─────────────▼───────────────────────┐      220
            │  Compression de la tension mesurée,   │
            │   détermination de l'ensemble de      │
            │   grandeurs représentatives et        │
            │  élaboration du premier message M1    │
            └─────────────────────────────────────┘
                          │
            ┌─────────────▼───────────────────────┐      230
            │      Emission du premier message M1   │
            └─────────────────────────────────────┘
```

**FIG.4**

```
            ┌─────────────────────────────────────┐      400
            │     Réception des premier et deuxième │
            │          messages M1, M2              │
            └─────────────────────────────────────┘
                          │
            ┌─────────────▼───────────────────────┐      410
            │  Horodatage et stockage des valeurs reçues │
            └─────────────────────────────────────┘
                          │
            ┌─────────────▼───────────────────────┐      430
            │   Affichage des grandeurs mesurées et  │
            │   calculées                            │
            └─────────────────────────────────────┘
                          │
            ┌─────────────▼───────────────────────┐      440
            │ Communication des grandeurs mesurées et │
            │  calculées à un serveur distant        │
            └─────────────────────────────────────┘
```

**FIG.6**

| Initialisation et ouverture d'une fenêtre glissante de réception | 300 |

| Réception du premier message M1 | 310 |

| Synchronisation temporelle avec le premier dispositif | 320 |

| Mesure de l'intensité | 330 |

| Compression de l'intensité mesurée et calcul de l'énergie électrique | 340 |

| Elaboration du deuxième message M2 | 350 |

| Emission du deuxième message M2 selon un mécanisme de jeton distribué | 360 |

<u>FIG.5</u>

M1

| Préambule 4 octets | SFD 1 octet | PHD 1 octet | Données n octets | CRC 2 octets |

$T_e$    $D_r$    $D_f$    $T_r$    $D_m$    $T_m$

t

Emission radio par émetteur      IT par récepteur

<u>FIG.7</u>

FIG.8

EP 2 873 981 B1

**EP 2 873 981 B1**

## RÉFÉRENCES CITÉES DANS LA DESCRIPTION

**Documents brevets cités dans la description**

- WO 2013017663 A1